# EUROPEAN PATENT APPLICATION

(11) **EP 4 621 580 A1**
(43) Date of publication of application: **24.09.2025**
(21) Application number: 24216117.2
(22) Date of filing: 28.11.2024
(51) Int. Cl.: G06F 13/16, G06F 13/40, G06F 13/42

(54) **MEMORY SYSTEM**

(30) Priority: 21.03.2024 JP 2024045430
(71) Applicant: Kioxia Corporation, Tokyo 108-0023 (JP)
(72) Inventor: Tsuchiya, Shigehiro, Tokyo, 108-0023 (JP); Suzuki, Tomoaki, Tokyo, 108-0023 (JP)
(74) Representative: Marks & Clerk LLP

(57) **Abstract**

According to an embodiment, a memory system includes a memory chip including a first terminal group used for data and a second terminal group used for a packet, and a memor y controller configured to transmit and receive the data to and from the memory chip and transmit the packet to the me mory chip. In a case where a transfer operation of the data is performed once, the memory controller transmits to the memory chip a first packet indicating a start of data trans fer and a second packet indicating end of the data transfer. In a case where the transfer operation of the data is suc cessively performed twice, the memory controller transmits to the memory chip the first packet corresponding to a seco nd data transfer between a first data transfer and the seco nd data transfer, and does not transmit the second packet c orresponding to the first data transfer.

## Description

### CROSS-REFERENCE TO RELATED APPLICATIONS

This application is based upon and claims the benefit of priority from Japanese Patent Application No. 2024-045430, filed March 21, 2024.

### FIELD

Embodiments described herein relate generally to a memory system.

### BACKGROUND

As a memory system, a solid state drive (SSD) equipped with a non-volatile semiconductor memory, such as a NAND flash memory, is known.

### BRIEF DESCRIPTION OF THE DRAWINGS

FIG. 1 is a block diagram illustrating an example of an overall configuration of a memory system according to a first embodiment.
FIG. 2 is a block diagram illustrating the configuration of a memory chip provided in the memory system according to the first embodiment.
FIG. 3 is a circuit diagram of a memory cell array provided in the memory system according to the first embodiment.
FIG. 4 is a diagram illustrating an example of a sequence of an input operation of a command and an address in the memory system according to the first embodiment.
FIG. 5 is a diagram illustrating an example of a sequence of an output operation of status information in the memory system according to the first embodiment.
FIG. 6 is a diagram illustrating an example of a sequence of a data input operation in the memory system according to the first embodiment.
FIG. 7 is a diagram illustrating an example of a sequence of a data output operation in the memory system according to the first embodiment.
FIG. 8 is a diagram illustrating an example of a sequence for successively performing the data input operations twice in the memory system according to the first embodiment.
FIG. 9 is a diagram illustrating an example of a sequence for successively performing the data output operations twice in the memory system according to the first embodiment.
FIG. 10 is a diagram illustrating an example of a sequence for successively performing the data input operation and an output operation in the memory system according to the first embodiment.
FIG. 11 is a diagram illustrating an example of a sequence for successively performing the data output operation and the input operation in the memory system according to the first embodiment.
FIG. 12 is a block diagram illustrating an example of an overall configuration of a memory system according to a second embodiment.
FIG. 13 is a diagram illustrating an example of a sequence for successively performing data output operations multiple times in a memory chip coupled to channel CH0a of a bridge chip and in a memory chip coupled to channel CH0b of the same bridge chip in the memory system according to the second embodiment.
FIG. 14 is a block diagram illustrating an example of an overall configuration of a memory system according to a third embodiment.
FIG. 15 is a diagram illustrating an example of a case where output data is output from a bridge chip to a memory controller in the memory system according to the third embodiment.
FIG. 16 a diagram illustrating an example of a case where output data is output from the bridge chip to the memory controller in the memory system according to the third embodiment.

### DETAILED DESCRIPTION

In general, according to one embodiment, a memory system includes a memory chip including a first terminal group used for transmitting and receiving data and a second terminal group used for receiving a packet, and configured to store the data in a non-volatile manner, and a memory controller configured to control the memory chip, transmit and receive the data to and from the memory chip via the first terminal group, and transmit the packet to the memory chip via the second terminal group. In a case where a transfer operation of the data to the memory chip is performed once, the memory controller transmits to the memory chip a first packet indicating a start of data transfer and a second packet indicating end of the data transfer. In a case where the transfer operation of the data to the memory chip is successively performed twice, the memory controller transmits to the memory chip the first packet corresponding to a second data transfer between a first data transfer and the second data transfer, and does not transmit the second packet corresponding to the first data transfer.

Embodiments will be described with reference to the accompanying drawings. In the descriptions below, structural elements having similar functions and configurations will be denoted by the same reference symbols. To distinguish a plurality of structural elements having common reference numerals, suffixes will be attached to the common reference numerals. If the structural elements do not need to be distinguished specifically, only the common reference numerals will be used, and no suffixes will be attached. The suffixes are not limited to subscripts and superscripts, but include, for example, lower-case English letters added at the end of reference numerals, and indices or the like indicating arrangements.

### 1. First Embodiment

The memory system according to a first embodiment will be described.

### 1.1 Configuration

### 1.1.1 Configuration of Memory System

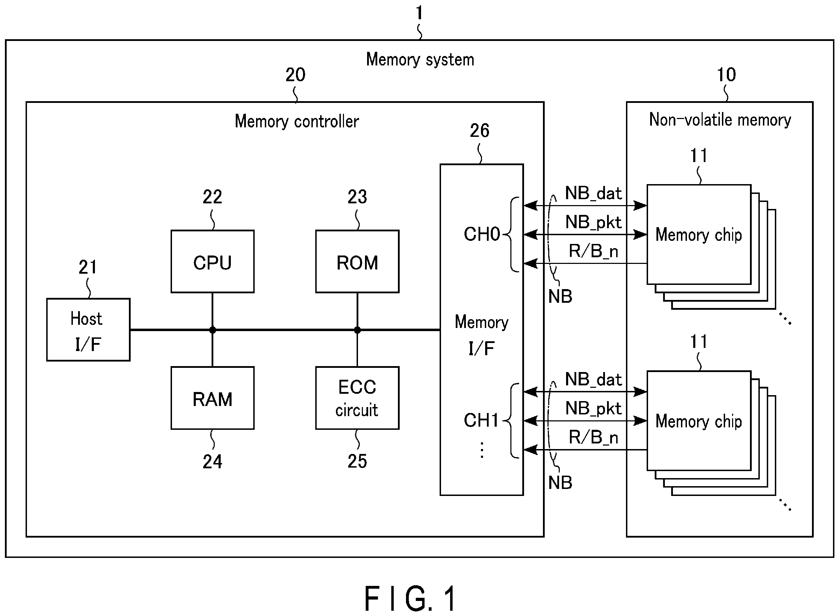

First, with reference to FIG. 1, an example of a configuration of a memory system 1 will be described. FIG. 1 is a block diagram illustrating an example of an overall configuration of the memory system 1. In the example shown in FIG. 1, some of the couplings between the components are indicated by arrows, but the couplings between the components are not limited to these.

As shown in FIG. 1, the memory system 1 is, for example, a solid state drive (SSD). The memory system 1 is coupled to a host device (not shown). For example, the memory system 1 is controlled by the host device.

The memory system 1 includes a non-volatile memory 10 and a memory controller 20.

The non-volatile memory 10 is a non-volatile storage medium. The non-volatile memory 10 stores data received from the memory controller 20 in a non-volatile manner.

The memory controller 20 is, for example, a system on a chip (SoC). For example, based on a request (instruction) from the host device, the memory controller 20 instructs the non-volatile memory 10 to perform a read operation, a write operation, an erase operation, etc. The memory controller 20 manages the memory space of the non-volatile memory 10.

Next, a description will be given of an example of an internal configuration of the non-volatile memory 10. The non-volatile memory 10 includes a plurality of memory chips 11.

Each memory chip 11 is, for example, a semiconductor memory device equipped with a NAND flash memory. The memory chip 11 stores data in a non-volatile manner. The memory chip 11 may be another type of non-volatile memory.

Each of the plurality of memory chips 11 can operate independently. Each memory chip 11 is coupled to the memory controller 20 via a NAND bus NB. The number of NAND buses NB and the number of memory chips 11 coupled to one NAND bus NB are arbitrary. A communication between the memory controller 20 and the memory chips 11 conforms, for example, to a toggle double data rate (DDR) interface or an open NAND flash interface (ONFI).

The memory chip 11 transmits and receives a signal group NB_dat and a signal group NB_pkt to and from the memory controller 20 (more specifically, the memory interface circuit 26) via the NAND bus NB. The signal group NB_dat includes a plurality of signals related to a transmission and reception of data. The signal group NB_pkt includes a plurality of signals related to a transmission and reception of packets. Also, the memory chip 11 transmits a signal R/B_n to the memory controller 20 via the NAND bus NB. Details of the signal group NB_dat, signal group NB_pkt, and signal R/B_n will be described later.

Next, a description will be given of an example of an internal configuration of the memory controller 20. The memory controller 20 includes a host interface circuit (host I/F) 21, a central processing unit (CPU) 22, a read only memory (ROM) 23, a random access memory (RAM) 24, an error check and correction (ECC) circuit 25, and a memory interface circuit (memory I/F) 26. These circuits are coupled to each other, for example, via an internal bus of the memory controller 20. The functions of the host interface circuit 21, the ECC circuit 25, and the memory interface circuit 26 may be realized by dedicated circuits, or may be realized by causing the CPU 22 to execute firmware.

The host interface circuit 21 is an interface circuit coupled to the host device. The host interface circuit 21 controls communication between the host device and the memory controller 20. The host interface circuit 21 transmits requests and data that are received from the host device to the CPU 22 and the RAM 24, respectively. The host interface circuit 21 also transmits data in the RAM 24 to the host device, based on control by the CPU 22.

The CPU22 is a processor. The CPU 22 controls an overall operation of the memory controller 20. For example, the CPU 22 instructs the non-volatile memory 10 (memory chip 11) to perform a write operation, a read operation, an erase operation, etc., based on the requests from the host device. The CPU 22 also manages the memory area of the non-volatile memory 10.

The ROM 23 is a non-volatile memory. For example, the ROM 23 is an electrically erasable programmable read-only memory (EEPROM^{™}). The ROM 23 is a non-temporary storage medium that stores firmware, programs, etc. For example, the CPU 22 develops the firmware loaded from the ROM 23 to the RAM 24.

The RAM 24 is a volatile memory. The RAM 24 is a dynamic random access memory (DRAM), a static random access memory (SR_AM), or the like. The RAM 24 is used as a work area of the CPU 22. For example, the RAM 24 stores firmware for managing the non-volatile memory 10 and various management tables. The RAM 24 also temporarily stores data read from the non-volatile memory 10, data received from the host device, etc.

The ECC circuit 25 is a circuit that executes ECC processing. The ECC processing includes data encoding processing and decoding processing. For example, in the write operation, the ECC circuit 25 executes data encoding processing to generate an error correction code (parity). The ECC circuit 25 then assigns the parity to the data. Furthermore, the ECC circuit 25 executes data decoding processing in the read operation. In other words, the ECC circuit 25 executes data error correction processing using the parity. In the description below, data that is processed collectively when the ECC circuit 25 encodes and decodes data will be referred to as an "ECC frame" or a "data frame."

The memory interface circuit 26 controls communication between the memory controller 20 and the non-volatile memory 10. The memory interface circuit 26 can have a plurality of channels CH (CH0, CH1, ...). Each channel CH is coupled to one or more memory chips 11 via a NAND bus NB.

### 1.1.2 Configuration of Memory Chip

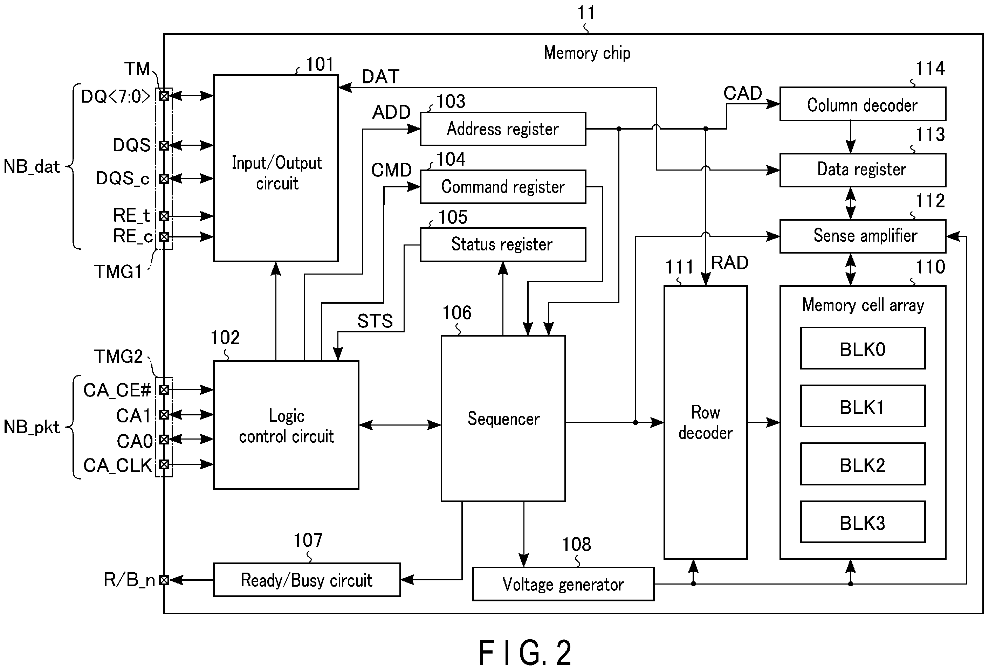

Next, an example of a configuration of the memory chip 11 will be described with reference to FIG. 2. FIG. 2 is a block diagram illustrating an example of the configuration of the memory chip 11. In the example shown in FIG. 2, some of the couplings between the components are indicated by arrows, but the couplings between the components are not limited to these.

In the present embodiment, a description will be given of a case where input/output of data DAT between the memory controller 20 and the memory chip 11, and input of a command CMD and an address ADD from the memory controller 20 to the memory chip 11 are performed using different signals (signal lines) of the NAND bus NB. In the description below, such a communication protocol will be referred to as the "separate command address input (SCA) protocol."

As shown in FIG. 2, the memory chip 11 includes an input/output circuit 101, a logic control circuit 102, an address register 103, a command register 104, a status register 105, a sequencer 106, a ready/busy circuit 107, a voltage generator 108, a memory cell array 110, a row decoder 111, a sense amplifier 112, a data register 113, and a column decoder 114.

The input/output circuit 101 is a circuit that inputs and outputs data DAT. The input/output circuit 101 is coupled to the NAND bus NB, i.e., to the memory controller 20 (more specifically, to the memory interface circuit 26), via a plurality of terminals TM (external coupling terminals). In the description below, a set of terminals TM coupled to the input/output circuit 101 will be referred to as a "first terminal group TMG1." For example, the input/output circuit 101 transmits and receives 8-bit signals DQ<7:0> and signals DQS and DQS_c to and from the memory controller 20 via the first terminal group TMG1. Furthermore, the input/output circuit 101 receives signals RE_t and RE_c from the memory controller 20 via the first terminal group TMG1. In a case where the signals DQ<7:0> do not have to be discriminated from each other, they will be simply referred to as "signal DQ." The signal DQ is data DAT. The signals DQS and DQS_c are strobe signals (clock signals) used for inputting and outputting the signal DQ. The signal DQS_c is an inverted signal of the signal DQS. The signals RE_t and RE_c are read enable signals for the memory controller 20 to read the data DAT from the memory chip 11. The signal RE_c is an inverted signal of the signal RE_t. The signals RE_t and RE_c are asserted, for example, at a low ("L") level. For example, when outputting the data DAT, the input/output circuit 101 generates signals DQS and DQS_c, based on the signals RE_t and RE_c. The signals RE_t and RE_c are not used for outputting packets.

In the description below, a set of signals DQ, DQS, DQS_c, RE_t, and RE_c used for inputting and outputting the data DAT will be referred to as a "signal group NB_dat." That is, a set of signals input and output at the input/output circuit 101 constitute the signal group NB_dat. In other words, the input/output circuit 101 transmits and receives the signal group NB_dat to and from the memory controller 20 via the first terminal group TMG1. The input/output circuit 101 is coupled to the logic control circuit 102 and the data register 113. The input/output circuit 101 transmits and receives the data DAT to and from the data register 113.

The logic control circuit 102 is a circuit that performs logic control of the memory chip 11. The logic control circuit 102 controls the input/output circuit 101 and the sequencer 106. The logic control circuit 102 is coupled to the NAND bus NB, i.e., to the memory controller 20, via a plurality of terminals TM. In the description below, a set of terminals TM coupled to the logic control circuit 102 will be referred to as a "second terminal group TMG2." The logic control circuit 102 transmits and receives a plurality of signals to and from the memory controller 20 via the second terminal group TMG2. In the description below, a set of signals that are input and output via the second terminal group TMG2 in the logic control circuit 102 will be referred to as a "signal group NB_pkt." The logic control circuit 102 transmits and receives the signal group NB_pkt to and from the memory controller 20 via the second terminal group TMG2. More specifically, the logic control circuit 102 receives signals CA_CE# and CA_CLK from the memory controller 20. Also, the logic control circuit 102 transmits and receives signals CA1 and CA0 to and from the memory controller 20. For example, the signals CA1 ,CA0, and CA_CLK are used for inputting and outputting packets, which are to be described later. Therefore, the signal group NB_pkt is used for inputting and outputting the packets.

The signal CA_CE# is a signal for enabling the memory chip 11. The signal CA_CE# is asserted, for example, at the "L" level.

The signals CA0 and CA1 are signals indicating information other than the data DAT, such as the command CMD, the address ADD, status information STS, and information related to the setting values of various operations. The signals CA0 and CA1 will be described later.

The signal CA_CLK is a strobe signal for the signals CA0 and CA1. For example, the logic control circuit 102 captures the signals CA0 and CA1 at a rising edge and a falling edge of the signal CA_CLK.

The logic control circuit 102 is coupled to the input/output circuit 101, the address register 103, the command register 104, the status register 105, and the sequencer 106. The logic control circuit 102 transmits the address ADD to the address register 103. The logic control circuit 102 transmits the command CMD to the command register 104. The logic control circuit 102 receives the status information STS from the status register 105. For example, the status information STS includes information about the results of the write operation, the read operation, the erase operation, etc. The logic control circuit 102 receives information about various settings such as voltage settings from a register (not shown) in the sequencer 106, for example.

The address register 103 is a register that temporarily stores the address ADD. The address register 103 is coupled to the logic control circuit 102, the sequencer 106, the row decoder 111, and the column decoder 114. The address ADD includes a row address RAD and a column address CAD. The address register 103 transmits the row address RAD to the row decoder 111. The address register 103 also transmits the column address CAD to the column decoder 114.

The command register 104 is a register that temporarily stores the command CMD. The command register 104 is coupled to the logic control circuit 102 and the sequencer 106. The command register 104 transmits the command CMD to the sequencer 106.

The status register 105 is a register that temporarily stores status information STS. The status register 105 is coupled to the logic control circuit 102 and the sequencer 106. The status register 105 receives the status information STS from the sequencer 106.

The sequencer 106 is a circuit that controls an overall operation of the memory chip 11. The sequencer 106 is coupled to the logic control circuit 102, the address register 103, the command register 104, the status register 105, the ready/busy circuit 107, the voltage generator 108, the row decoder 111, the sense amplifier 112, etc. The sequencer 106 controls the status register 105, ready/busy circuit 107, the voltage generator 108, the row decoder 111, the sense amplifier 112, etc. The sequencer 106 executes the write operation, the read operation, and the erase operation, based on the command CMD.

The ready/busy circuit 107 is a circuit that generates a signal R/B_n. The signal R/B_n is a signal that indicates whether the memory chip 11 is in a state where it can receive the command CMD from the memory controller 20 (ready state) or cannot receive it (busy state). For example, the signal R/B_n is set to the "L" level when memory chip 11 is in a busy state. For example, the ready/busy circuit 107 is coupled to the sequencer 106. The ready/busy circuit 107 generates the signal R/B_n, based on the control of the sequencer 106. The ready/busy circuit 107 is coupled to the NAND bus NB, i.e., to the memory controller 20, via terminal TM. The ready/busy circuit 107 transmits the signal R/B_n to the memory controller 20.

The voltage generator 108 generates various voltages used in the write operation, the read operation, and the erase operation, based on the control of the sequencer 106. The voltage generator 108 supplies various voltages to the memory cell array 110, the row decoder 111, the sense amplifier 112, and the like.

The memory cell array 110 is a set of memory cell transistors (also referred to as "memory cells") that are arranged. The memory cell array 110 includes a plurality of blocks BLK. The block BLK is, for example, a set of memory cell transistors from which data is erased collectively. In the example shown in FIG. 2, the memory cell array 110 includes four blocks BLK0, BLK1, BLK2, and BLK3. The number of blocks BLK in the memory cell array 110 is arbitrary.

The row decoder 111 is a decode circuit for the row address RAD. The row decoder 111 is coupled to the address register 103, the sequencer 106, the voltage generator 108, and the memory cell array 110. The row decoder 111 selects one of the blocks BLK, based on the decoding result of the row address RAD. The row decoder 111 applies voltages to interconnects extending in the row direction (i.e., to word lines and select gate lines to be described later) of the selected block BLK.

The sense amplifier 112 is a circuit that writes and reads data. The sense amplifier 112 is coupled to the sequencer 106, the voltage generator 108, the memory cell array 110, and the data register 113. The sense amplifier 112 reads data from the memory cell array 110 in the read operation. The sense amplifier 112 also supplies voltages corresponding to the write data to the memory cell array 110 in the write operation.

The data register 113 is a register that temporarily stores data DAT. The data register 113 is coupled to the input/output circuit 101, the sequencer 106, the sense amplifier 112, and the column decoder 114. The data register 113 includes a plurality of latch circuits. Each latch circuit temporarily stores write data or read data.

The column decoder 114 is a circuit that decodes a column address CAD. The column decoder 114 is coupled to the address register 103, the sequencer 106, and the data register 113. The column decoder 114 receives the column address CAD from the address register 103. The column decoder 114 selects the latch circuits in the data register 113, based on the decoding result of the column address CAD.

### 1.1.3 Circuit Configuration of Memory Cell Array

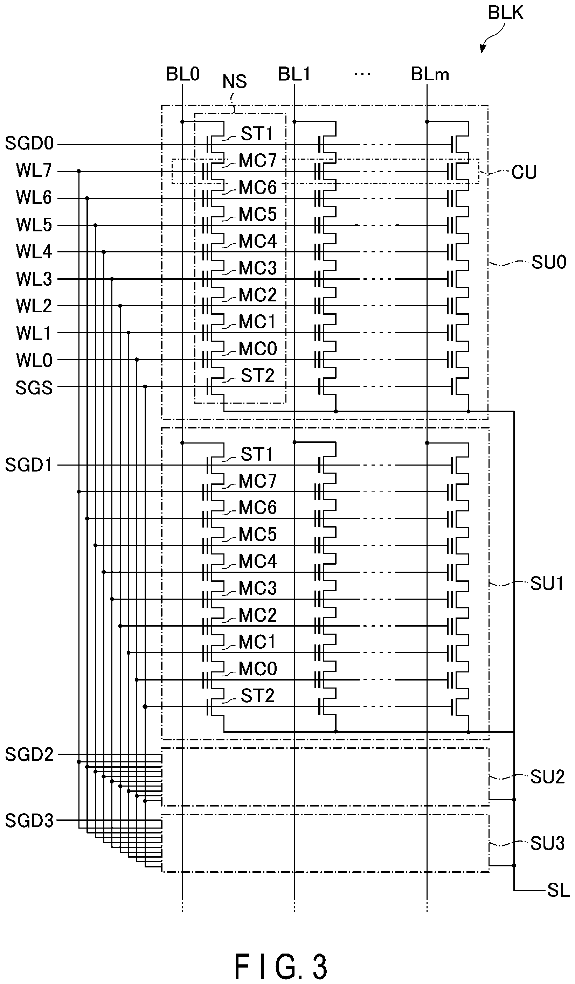

Next, a description will be given of an example of a circuit configuration of the memory cell array 110 with reference to FIG. 3. FIG. 3 is a circuit diagram of the memory cell array 110. The example in FIG. 3 shows a circuit configuration of one block BLK.

As shown in FIG. 3, the block BLK includes a plurality of string units SU. The string unit SU is, for example, a set of NAND strings NS that are selected collectively in the write operation or the read operation. In the example shown in FIG. 3, the block BLK includes four string units SU0 to SU3. The number of string units SU included in the block BLK is arbitrary.

Next, an internal configuration of the string unit SU will be described. The string unit SU includes a plurality of NAND strings NS. Each NAND string NS includes a plurality of memory cell transistors MC coupled in series. For example, m+1 NAND strings NS (m is an integer equal to or greater than 1) of the string unit SU are coupled to m+1 bit lines BL0 to BLm, respectively.

Next, an internal configuration of the NAND string NS will be described. Each NAND string NS includes a plurality of memory cell transistors MC and select transistors ST1 and ST2. In the example shown in FIG. 3, the NAND string NS includes eight memory cell transistors MC0 to MC7. The number of memory cell transistors MC included in the NAND string NS is arbitrary.

The memory cell transistors MC store data in a non-volatile manner. Each of the memory cell transistors MC includes a control gate and a charge storage layer. The memory cell transistors MC may be either a metal-oxide-nitride-oxide-silicon (MONOS) type or a floating gate (FG) type. The MONOS type uses an insulating layer for the charge storage layer. The FG type uses a conductor layer for the charge storage layer.

The select transistors ST1 and ST2 are used for selecting the string unit SU during various operations. The number of select transistor ST1 and ST2 may be arbitrary. Each NAND string NS may include one or more select transistors ST1 and ST2.

The current paths of the memory cell transistors MC and select transistors ST1 and ST2 in each NAND string NS are coupled in series. More specifically, the current paths are coupled in series in the order of the select transistor ST2, the memory cell transistors MC0 to MC7, and the select transistor ST1. A drain of the select transistor ST1 is coupled to one of the bit lines BL. A source of the select transistor ST2 is coupled to a source line SL.

The control gates of the plurality of memory cell transistors MC0 to MC7 in the same block BLK are commonly coupled to the word lines WL0 to WL7, respectively. More specifically, for example, the block BLK includes four string units SU0 to SU3. The string units SU0 to SU3 each include a plurality of memory cell transistors MC0. The control gates of these plurality of memory cell transistors MC0 in the block BLK are commonly coupled to one word line WL0. This holds true of the other memory cells MC1 to MC7 as well.

The gates of the plurality of select transistors ST1 in a string unit SU are commonly coupled to one select gate line SGD. More specifically, the string unit SU0 includes a plurality of select transistors ST1. The gates of the plurality of select transistors ST1 in the string unit SU0 are commonly coupled to a select gate line SGD0. Similarly, the gates of the plurality of select transistors ST1 in the string unit SU1 are commonly coupled to a select gate line SGD1. The gates of the plurality of select transistors ST1 in the string unit SU2 are commonly coupled to a select gate line SGD2. The gates of the plurality of select transistors ST1 in the string unit SU3 are commonly coupled to a select gate line SGD3.

The gates of the plurality of select transistors ST2 in the same block BLK are commonly coupled to one select gate line SGS. More specifically, for example, the block BLK includes four string units SU0 to SU3. The string units SU0 to SU3 each include a plurality of select transistors ST2. The gates of the plurality of select transistors ST2 in the block BLK are commonly coupled to one select gate line SGS. Similarly to the select gate line SGD, a different select gate line SGS may be provided for each string unit SU.

The word lines WL0 to WL7, the select gate lines SGD0 to SGD3, and the select gate line SGS are coupled to the row decoder 111.

The bit line BL is commonly coupled to one NAND string NS in each string unit SU of each block BLK. The same column address CAD is assigned to a plurality of NAND strings NS coupled to one bit line BL. Each bit line BL is coupled to the sense amplifier 112.

The source line SL is shared, for example, by the plurality of blocks BLK.

A set of memory cell transistors MC coupled to one word line WL in one string unit SU are referred to as a cell unit CU. In other words, the cell unit CU is a set of memory cell transistors MC that are collectively selected in the write operation or the read operation. A page is a unit of data that is collectively written to the cell unit CU (or collectively read therefrom). For example, in a case where the memory cell MC stores 1-bit data, the storage capacity of the cell unit CU is 1 page. That is, the cell unit CU stores one-page data. The one-page data may be the same as the data size of an ECC frame, or the one-page data may include a plurality of ECC frames. The cell unit CU may have a storage capacity of two or more pages, based on the number of bits of data stored in the memory cell transistor MC.

### 1.2 Sequence of Input/Output Operation

Next, a sequence of the input/output operation between the memory controller 20 and the memory chip 11 will be described.

### 1.2.1 Sequence of Packet Input Operation

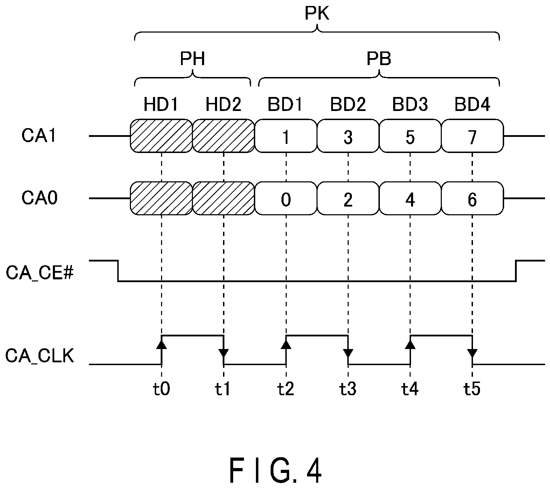

First, an example of a sequence of an input operation of a packet PK will be described with reference to FIG. 4. FIG. 4 is a diagram illustrating an example of the sequence of the input operation of the packet PK. In the example shown in FIG. 4, signals other than the signal group NB_pkt are omitted.

As shown in FIG. 4, the signals CA0 and CA1 are each 1-bit signals. The signals CA0 and CA1 are transferred in synchronization with the timing of the rising edge and falling edge of a signal CA_CLK, respectively. For example, 12-bit data, including both the signal CA0 and the signal CA1, are transferred during three cycles of the CA_CLK signal. In the description below, the 12-bit data in which the signal CA0 and the signal CA1 are combined will be defined as a "packet PK." The packet PK includes 4-bit data indicating the type of information and 8-bit data indicating the contents of the information. Types of information include, for example, the command CMD, the address ADD, a CA_Data_Output, an SCE packet, and an SCT packet. The CA_Data_Output is a data output operation using signals CA0 and CA1 (hereinafter referred to as "CA_Data_Output operation" as well). The size of the data read by the CA_Data_Output operation is smaller than the data DAT (read data) read from the memory cell array 110. Specifically, the CA_Data_Output operation corresponds to reading status information STS from the status register 105, reading values (information on setting values for various operations) from the sequencer 106 (from a register thereof, not shown), or the like. The SCE packet indicates the start of data transfer using the signal DQ. The SCT packet indicates the end of the data transfer using the signal DQ. In the description below, 4-bit data indicating the type of information will be referred to as a "packet header PH." The 8-bit data indicating the contents of the information will be referred to as a "packet body PB." In other words, a packet PK is a combination of the packet header PH and the packet body PB.

The packet header PH is a set of 4 bits consisting of the first 2 bits of signal CA0 and the first 2 bits of signal CA1 in the packet PK. In the description below, each bit of the packet header PH will be referred to as a "header HD." More specifically, in each of the signals CA0 and CA1, the first bit in the packet header PH will be referred to as a "first header HD1." The second bit in the packet header PH will be referred to as a "second header HD2."

The packet body PB is a set of 8 bits consisting of the last 4 bits of signal CA0 and the last 4 bits of signal CA1 in the packet PK. In the description below, each bit of the packet body PB will be referred to as a "body BD." More specifically, in each of the signals CA0 and CA1, the first bit in the packet body PB will be referred to as a "first body BD1." The second bit in the packet body PB will be referred to as a "second body BD2." The third bit in the packet body PB is referred to as a "third body BD3." The fourth bit in the packet body PB will be referred to as a "fourth body BD4."

The memory controller 20 first sets the signal CA_CE# corresponding to the target memory chip 11 to the "L" level. This enables the target memory chip 11.

The memory controller 20 transmits the first headers HD1 of the signals CA0 and CA1 to the memory chip 11. The memory controller 20 also starts transmitting the signal CA_CLK to the memory chip 11. The memory chip 11 captures the first headers HD1 in synchronization with the rising edge of the signal CA_CLK at time t0.

Next, the memory controller 20 transmits the second headers HD2 of the signals CA0 and CA1 to the memory chip 11. The memory chip 11 captures the second headers HD2 in synchronization with the falling edge of the signal CA_CLK at time t1.

Next, the memory controller 20 transmits the first bodies BD1 of the signals CA0 and CA1 to the memory chip 11. The memory chip 11 captures the first bodies BD1 in synchronization with the rising edge of the signal CA_CLK at time t2.

Next, the memory controller 20 transmits the second bodies BD2 of the signals CA0 and CA1 to the memory chip 11. The memory chip 11 captures the second bodies BD2 in synchronization with the falling edge of the signal CA_CLK at time t3.

Next, the memory controller 20 transmits the third bodies BD3 of the signals CA0 and CA1 to the memory chip 11. The memory chip 11 captures the third bodies BD3 in synchronization with the rising edge of the signal CA_CLK at time t4.

Next, the memory controller 20 transmits the fourth bodies BD4 of the signals CA0 and CA1 to the memory chip 11. The memory chip 11 captures the fourth bodies BD4 in synchronization with the falling edge of the signal CA_CLK at time t5.

For example, when the memory controller 20 finishes transmitting the packet PK, it sets the signal CA_CE# to the High ("H") level.

The signal group NB_dat (signal DQ, signals DQS and DQS_c, and signals RE_t and RE_c) are not used for input of the packet PK (command CMD, address ADD, SCE packet, SCT packet, etc.). For this reason, input of the packet PK (command CMD, address ADD, SCE packet, SCT packet, etc.) can be performed in parallel with input/output of data DAT using the signal group NB_dat.

### 1.2.2 Sequence of CA_Data_Output Operation

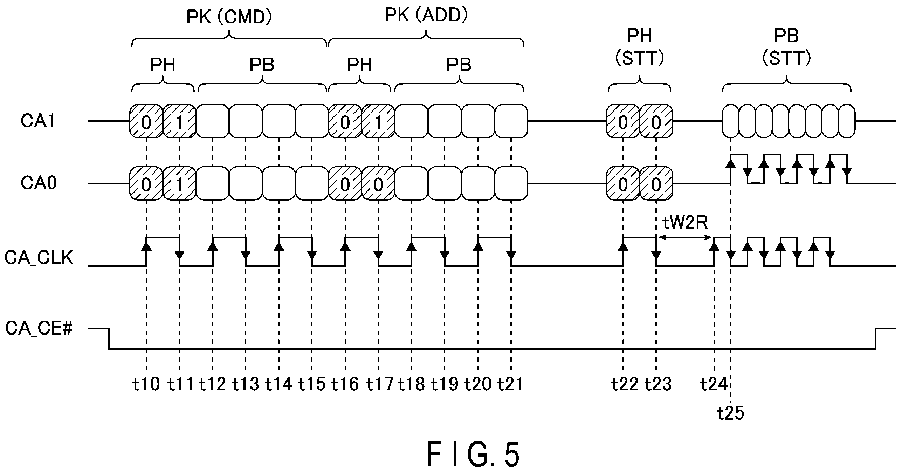

Next, with reference to FIG. 5, a sequence of an output operation of status information STS will be described as an example of the CA_Data_Output operation. FIG. 5 is a diagram illustrating an example of the sequence of the output operation of the status information STS. In the example shown in FIG. 5, signals other than the signal group NB_pkt are omitted.

As shown in FIG. 5, the memory controller 20 first sets the signal CA_CE# corresponding to the target memory chip 11 to the "L" level. This enables the target memory chip 11. Next, from time t10 to time t15, the input operation of the packet PK (PK(CMD)) corresponding to the command CMD instructing the execution of the CA_Data_Output operation is performed.

More specifically, at time t10, for example, the first header HD1 of the signal CA0 indicating "0" and the first header HD1 of the signal CA1 indicating "0" are first input to the memory chip 11.

Next, at time t11, for example, the second header HD2 of the signal CA0 indicating "1" and the second header HD2 of the signal CA1 indicating "1" are input to the memory chip 11. For example, a packet header PH of "0", "0", "1", "1" indicates that the packet body PB to be input next is the command CMD.

Next, in the period from time t12 to time t15, the packet body PB of the command CMD is input to the memory chip 11. At this time, for example, a packet body PB corresponding to the status information STS is input. In a case where a value is read from the sequencer 106, different packet bodies PB are input. More specifically, at time t12, the first bodies BD1 of the signal CA0 and signal CA1 are input to the memory chip 11. Next, at time t13, the second bodies BD2 of the signal CA0 and signal CA1 are input to the memory chip 11. Next, at time t14, the third bodies BD3 of the signal CA0 and signal CA1 are input to the memory chip 11. Next, at time t15, the fourth bodies BD4 of the signal CA0 and signal CA1 are input to the memory chip 11.

Next, in the period from time t16 to time t21, an input operation of the packet PK (PK(ADD)) corresponding to the address ADD is executed.

More specifically, at time t16, for example, the first header HD1 of the signal CA0 indicating "0" and the first header HD1 of the signal CA1 indicating "0" are first input to the memory chip 11.

Next, at time t17, for example, the second header HD2 of the signal CA0 indicating "0" and the second header HD2 of the signal CA1 indicating "1" are input to the memory chip 11. For example, a packet header PH of "0", "0", "0", "1" indicates that the packet body PB to be input next is the address ADD.

Next, in the period from time t18 to time t21, the packet body PB of the address ADD is input to the memory chip 11. More specifically, at time t18, the first bodies BD1 of the signal CA0 and signal CA1 are input to the memory chip 11. Next, at time t19, the second bodies BD2 of the signal CA0 and signal CA1 are input to the memory chip 11. Next, at time t20, the third bodies BD3 of the signal CA0 and signal CA1 are input to the memory chip 11. Next, at time t21, the fourth bodies BD4 of the signal CA0 and the signal CA1 are input to the memory chip 11.

When the input of the address ADD ends at time t21, the sequencer 106 starts, for example, a read operation of the status information STS from the target address of the status register 105 to the logic control circuit 102. In a case where a value is read from the sequencer 106, a read operation from the sequencer 106 to the logic control circuit 102 is started.

In the period from time t21 to time t22, a read operation to the logic control circuit 102 is executed. The value read to the logic control circuit 102 (in this example, the status information STS) is stored in a register (not shown) of the logic control circuit 102.

In the period from time t22 to time t23, the memory controller 20 transmits a packet header PH (PH(STT)) to the memory chip 11, which instructs the logic control circuit 102 to output the read value.

More specifically, at time t22, for example, the first header HD1 of the signal CA0 indicating "0" and the first header HD1 of the signal CA1 indicating "0" are first input to the memory chip 11.

Next, at time t23, for example, the second header HD2 of the signal CA0 indicating "0" and the second header HD2 of the signal CA1 indicating "0" are input to the memory chip 11. For example, a packet header PH of "0", "0", "0", "0" is a packet header PH that instructs the logic control circuit 102 to output the read value.

The period from time t23 to time t24 is a standby period (period tW2R) for switching the input and output of signals CA0 and CA1. The signals CA0 and CA1 in the period from time t10 to time t23 are input signals to the memory chip 11. In contrast, the signals CA0 and CA1 from time t24 onwards are output signals from the memory chip 11.

Next, the memory controller 20 transmits the signal CA_CLK to the memory chip 11 to designate the timing at which the status information STS is output. More specifically, at time t24, the memory controller 20 transmits the signal CA_CLK of the "H" level to the memory chip 11. At time t25, the memory controller 20 transmits the signal CA_CLK of the "L" level to the memory chip 11. After time t24, the memory controller 20 toggles the signal CA_CLK (switching between the "L" level and the "H" level) four times.

Based on the signal CA_CLK, the value read to the logic control circuit 102 is output. The logic control circuit 102 outputs a signal CA1 as the value read to the logic control circuit 102. The logic control circuit 102 also outputs the signal CA0 as a strobe signal for the signal CA1. The logic control circuit 102 generates the signal CA0, based on the signal CA_CLK.

The value read to the logic control circuit 102 is output as the signal CA1 in synchronization with the rising and falling edges of the signal CA0. An 8-bit packet body PB output as the signal CA1 corresponds to the 8-bit data output. The signal CA1 is output in synchronization with the rising or falling edge of the signal CA0. Therefore, even if "0" or "1" is output in succession as signal CA1, the data boundary can be determined.

When the output of the 8-bit packet body PB (signal CA1) is completed, the memory controller 20 sets the signal CA_CE# to the "H" level. This ends the CA_Data_Output operation. After the CA_Data_Output operation is ended, the signals CA0 and CA1 return (switch) from output signals to input signals to the memory chip 11. If the output value is data larger than 8 bits in size, the 8-bit packet body PB may be output multiple times in succession.

The signal group NB_dat is not used in the CA_Data_Output operation. For this reason, the CA_Data_Output operation can be performed in parallel with the input/output of data DAT using the signal group NB_dat.

### 1.2.3 Sequence of Data Input Operation

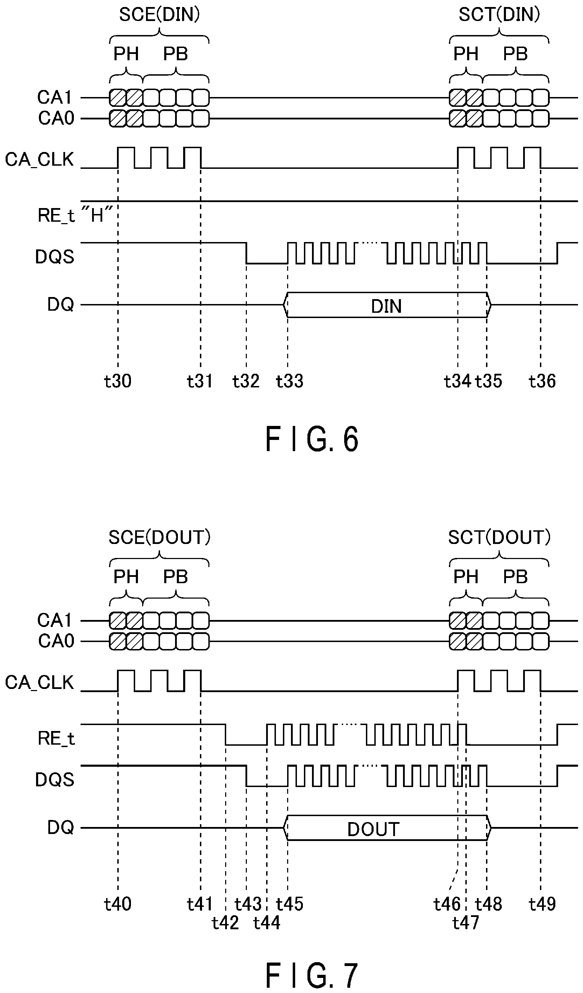

Next, an example of a sequence of an input operation of data DAT will be described with reference to FIG. 6. FIG. 6 is a diagram illustrating an example of the sequence of the input operation of the data DAT. In the description below, among the data DAT, the input data from the memory controller 20 to the memory chip 11 will be referred to as "input data DIN." For example, the input data DIN is write data. In the example shown in FIG. 6, the signal DQS_c, the signal CA_CE#, the signal RE_c, and the signal R/B_n are omitted. In addition, in order to simplify the description, the command CMD and the address ADD that instruct the execution of the input operation of the input data DIN (for example, a write operation) are omitted in the example shown in FIG. 6.

As shown in FIG. 6, in the period from time t30 to time t31, the memory controller 20 first transmits an SCE packet (SCE(DIN) shown in FIG. 6) to the memory chip 11. The packet header PH and the packet body PB corresponding to the SCE packet are input to the memory chip 11 in synchronization with the rising and falling edges of the signal CA_CLK.

At time t32, the memory controller 20 sets the signal DQS to the "L" level.

In the period from time t33 to time t35, the memory controller 20 transmits the signal DQ corresponding to the input data DIN to the memory chip 11 while repeatedly toggling the signal DQS. In other words, the input data DIN is input to the input/output circuit 101. In the description below, the period from the completion of the transmission of the SCE packet to the start of data transfer will be referred to as a "preamble period" as well. For example, the period from time t31 to time t33 is the preamble period.

In the period from time t34 to time t36, the memory controller 20 transmits an SCT packet (SCT(DIN) shown in FIG. 6) to the memory chip 11. The packet header PH and the packet body PB corresponding to the SCT packet are input to the memory chip 11 in synchronization with the rising and falling edges of the signal CA_CLK. In the period from time t34 to time t35, the input of input data DIN and the input of the SCT packet are executed in parallel. In the description below, the period starting from the end of data transfer and ending at the end of transmission of the SCT packet will be referred to as a "postamble period" as well. For example, the period from time t35 to t36 is the postamble period.

### 1.2.4 Sequence of Data Output Operation

Next, an example of a sequence of an output operation of data DAT will be described with reference to FIG. 7. FIG. 7 is a diagram illustrating an example of the sequence of the output operation of the data DAT. In the description below, among the data DAT, the output data from the memory chip 11 to the memory controller 20 will be referred to as "output data DOUT." For example, the output data DOUT is read data. In the example shown in FIG. 7, the signal DQS_c, the signal CA_CE#, the signal RE_c, and the signal R/B_n are omitted. In addition, in order to simplify the description, the command CMD and the address ADD that instruct the execution of the output operation (e.g., a read operation) of the output data DOUT are omitted in the example shown in FIG. 7.

As shown in FIG. 7, in the period from time t40 to time t41, the memory controller 20 first transmits an SCE packet (SCE(DOUT) shown in FIG. 7) to the memory chip 11. The packet header PH and the packet body PB corresponding to the SCE packet are input to the memory chip 11 in synchronization with the rising and falling edges of the signal CA_CLK.

At time t42, the memory controller 20 sets the signal RE_t to the "L" level (and the signal RE_c to the "H" level).

At time t43, the memory controller 20 sets the signal DQS to the "L" level.

At time t44, the memory controller 20 starts toggling the signal RE_t (and the signal RE_c). In the period from time t44 to time t47, the memory controller 20 repeatedly toggles the signal RE_t (and the signal RE_c). The memory chip 11 generates the signal DQS (and the signal DQS_c), based on the signal RE_t (and the signal RE_c).

In the period from time t45 to time t48, the memory chip 11 transmits the signal DQ corresponding to the output data DOUT to the memory controller 20 while repeatedly toggling the signal DQS. For example, the period from time t41 to time t45 is the preamble period.

In the period from time t46 to time t49, the memory controller 20 transmits an SCT packet (SCT(DOUT) shown in FIG. 7) to the memory chip 11. The packet header PH and the packet body PB corresponding to the SCT packet are input to the memory chip 11 in synchronization with the rising and falling edges of the signal CA_CLK. In the period from time t46 to time t48, the output of the output data DOUT and the input of the SCT packet are executed in parallel. For example, the period from time t48 to t49 is the postamble period.

### 1.3 Sequence for Successively Performing Data Transfer Operations Multiple Times

Next, a description will be given of a sequence for successively performing data DAT transfer operations (input operation and output operation) multiple times.

In the present embodiment, in a case where data DAT transfer operations (input operation and output operation) are successively performed multiple times, the memory controller 20 transmits the SCT packet to the memory chip 11 only when the last transfer operation is completed. In other words, the memory controller 20 omits transmission of the SCT packets in the transfer operations other than the last transfer operation and transmits the SCE packet corresponding to the next transfer operation. More specifically, for example, in a case where data DAT transfer operations are performed twice in succession, the memory controller 20 omits transmission of the SCT packet corresponding to the first transfer operation and transmits the SCE packet corresponding to the second transfer operation. Upon receipt of the SCE packet corresponding to the second transfer operation, the memory chip 11 recognizes the end of the first transfer operation and prepares for the next transfer operation.

### 1.3.1 Sequence for Successively Performing Data Input Operations Twice

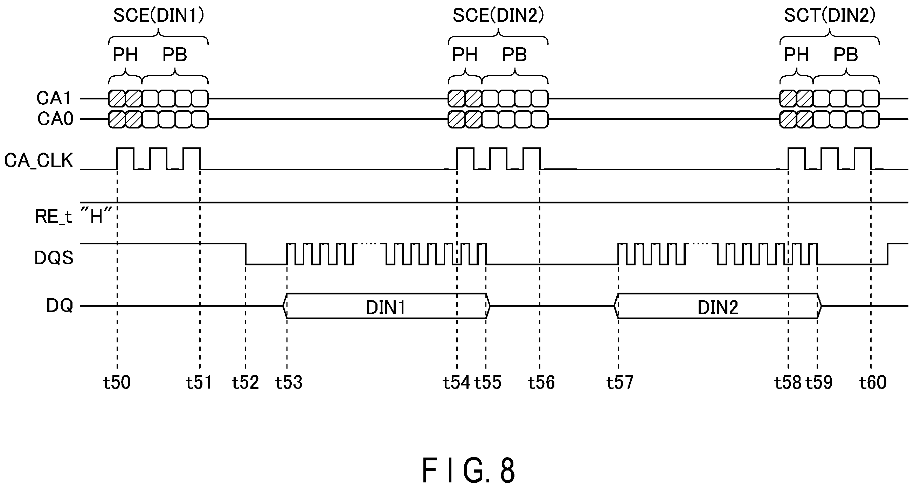

Next, with reference to FIG. 8, an example of a sequence for performing input operations of data DAT twice will be described. FIG. 8 is a diagram illustrating an example of the sequence for successively performing the input operation of the data DAT twice. FIG. 8 shows a case where an input operation of input data DIN1 and an input operation of input data DIN2 are executed in succession. For example, the input data DIN1 and the input data DIN2 correspond to write operations of different pages. In the example shown in FIG. 8, the signal DQS_c, the signal CA_CE#, the signal RE_c, and the signal R/B_n are omitted. In addition, in order to simplify the description, the command CMD and the address ADD that instruct the execution of the input operation of the data DAT (for example, a write operation) are omitted in the example shown in FIG. 8.

As shown in FIG. 8, the memory controller 20 first executes the input operation of the input data DIN1. In the period from time t50 to time t51, the memory controller 20 transmits an SCE packet (SCE(DIN1) shown in FIG. 8) corresponding to the input data DIN1 to the memory chip 11. The packet input operation in the period from time t50 to time t51 is similar to the packet input operation in the period from time t30 to time t31 described with reference to FIG. 6.

At time t52, the memory controller 20 sets the signal DQS to the "L" level.

In the period from time t53 to time t55, the memory controller 20 transmits the signal DQ corresponding to the input data DIN1 to the memory chip 11 while repeatedly toggling the signal DQS. That is, the input data DIN1 is input to the input/output circuit 101. The data input operation in the period from time t53 to time t55 is similar to the data input operation in the period from time t33 to time t35 described with reference to FIG. 6.

In the period from time t54 to time t56, as in the period from time t50 to time t51, the memory controller 20 transmits an SCE packet (SCE(DIN2) shown in FIG. 8) corresponding to the input data DIN2 to the memory chip 11. In other words, the transmission of the SCT packet corresponding to the input data DIN1 is omitted. In the period from time t54 to time t55, the input of the input data DIN1 and the input of an SCE packet corresponding to the input data DIN2 are executed in parallel.

The period from time t55 to time t57 is a standby period of the signal DQ from the completion of the input of the input data DIN1 to the start of the input of the input data DIN2.

In the period from time t57 to time t59, as in the period from time t53 to time t55, the memory controller 20 transmits the signal DQ corresponding to the input data DIN2 to the memory chip 11 while repeatedly toggling the signal DQS. That is, the input data DIN2 is input to the input/output circuit 101.

In the period from time t58 to time t60, the memory controller 20 transmits an SCT packet (SCT(DIN2) shown in FIG. 8) corresponding to the input data DIN2 to the memory chip 11. The packet input operation in the period from time t58 to time t60 is similar to the packet input operation in the period from time t34 to time t36 described with reference to FIG. 6. In the period from time t58 to time t59, the input of the input data DIN2 and the input of the SCT packet are executed in parallel.

### 1.3.2 Sequence for Successively Performing Data Output Operations Twice

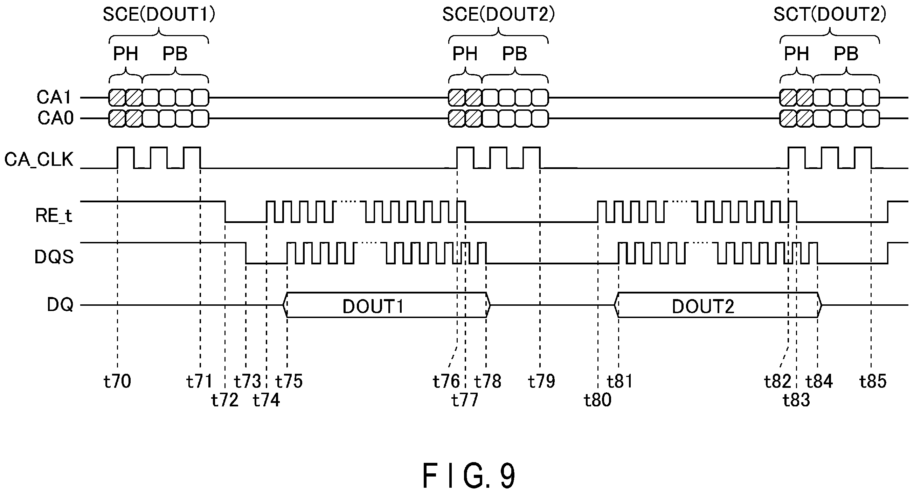

Next, with reference to FIG. 9, an example of a sequence for successively performing output operations of data DAT twice will be described. FIG. 9 is a diagram illustrating an example of the sequence for successively performing the output operation of the data DAT twice. FIG. 9 shows a case where an output operation of output data DOUT1 and an output operation of output data DOUT2 are executed in succession. For example, the output data DOUT1 and the output data DOUT2 correspond to the read operation of different pages. In the example shown in FIG. 9, the signal DQS_c, the signal CA_CE#, the signal RE_c, and the signal R/B_n are omitted. In addition, in order to simplify the description, the command CMD and the address ADD that instruct the execution of the output operation (e.g., a read operation) of the data DAT are omitted in the example shown in FIG. 9.

As shown in FIG. 9, the memory controller 20 first executes the output operation of the output data DOUT1. In the period from time t70 to time t71, the memory controller 20 transmits an SCE packet (SCE(DOUT1) shown in FIG. 9) corresponding to the output data DOUT1 to the memory chip 11. The packet input operation in the period from time t70 to time t71 is similar to the packet input operation in the period from time t40 to time t41 described with reference to FIG. 7.

At time t72, the memory controller 20 sets the signal RE_t to the "L" level (and the signal RE_c to the "H" level).

At time t73, the memory controller 20 sets the signal DQS to the "L" level.

At time t74, the memory controller 20 starts toggling the signal RE_t (and the signal RE_c). In the period from time t74 to time t77, the memory controller 20 repeatedly toggles the signal RE_t (and the signal RE_c). The memory chip 11 generates the signal DQS (and the signal DQS_c), based on the signal RE_t (and the signal RE_c).

In the period from time t75 to time t78, the memory chip 11 transmits the signal DQ corresponding to the output data DOUT1 to the memory controller 20 while repeatedly toggling the signal DQS. The data output operation in the period from time t75 to time t78 is similar to the data output operation in the period from time t45 to time t48 described with reference to FIG. 7.

In the period from time t76 to time t79, as in the period from time t70 to time t71, the memory controller 20 transmits an SCE packet (SCE(DOUT2) shown in FIG. 9) corresponding to the output data DOUT2 to the memory chip 11. In other words, the transmission of the SCT packet corresponding to the output data DOUT1 is omitted. In the period from time t76 to time t78, the output of the output data DOUT1 and the input of the SCE packet corresponding to the output data DOUT2 are executed in parallel.

In the period from time t80 to time t83, as in the period from time t74 to time t77, the memory controller 20 repeatedly toggles the signal RE_t (and the signal RE_c). The memory chip 11 generates the signal DQS (and the signal DQS_c), based on the signal RE_t (and the signal RE_c).

The period from time t78 to time t81 is a standby period of the signal DQ from the completion of the output of the output data DOUT1 to the start of the output of the output data DOUT2.

In the period from time t81 to time t84, as in the period from time t75 to time t78, the memory chip 11 transmits the signal DQ corresponding to the output data DOUT2 to the memory controller 20 while repeatedly toggling the signal DQS.

In the period from time t82 to time t85, the memory controller 20 transmits an SCT packet (SCT(DOUT2) shown in FIG. 9) corresponding to the output data DOUT2 to the memory chip 11. The packet input operation in the period from time t82 to time t85 is similar to the packet input operation in the period from time t46 to time t49 described with reference to FIG. 7. In the period from time t82 to time t84, the output of the output data DOUT2 and the input of the SCT packet are executed in parallel.

### 1.3.3 Sequence for Successively Performing Input Operation and Output Operation of Data

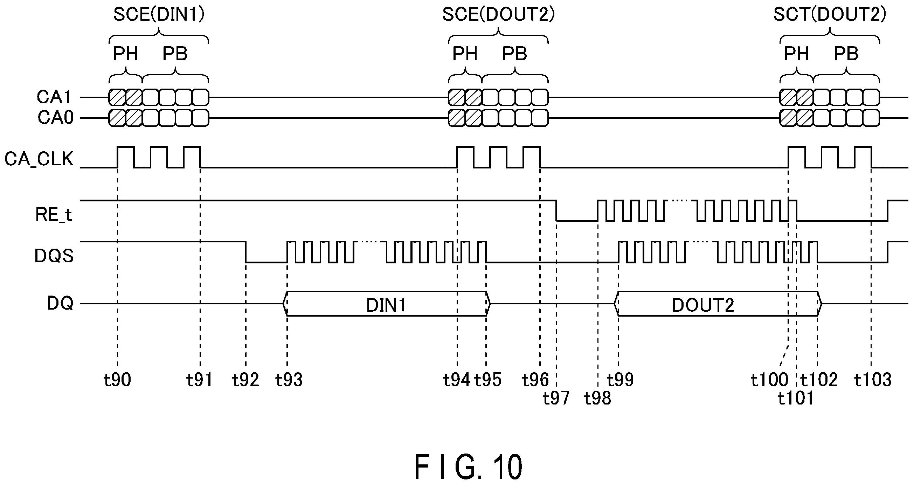

Next, with reference to FIG. 10, an example of a sequence for successively performing an input operation and an output operation of data DAT will be described. FIG. 10 is a diagram illustrating an example of the sequence for successively performing the input operation and the output operation of the data DAT. FIG. 10 shows a case where the input operation of input data DIN1 and the output operation of output data DOUT2 are executed in succession. In the example shown in FIG. 10, the signal DQS_c, the signal CA_CE#, the signal RE_c, and the signal R/B_n are omitted. In addition, in order to simplify the description, the command CMD and the address ADD that instruct the execution of a transfer operation (input operation and output operation) of the data DAT are omitted in the example shown in FIG. 10.

As shown in FIG. 10, the memory controller 20 first executes an input operation of the input data DIN1. The input operation of the input data DIN1 executed in the period from time t90 to time t95 is similar to the input operation of the input data DIN1 executed in the period from time t50 to time t55 described with reference to FIG. 8.

In the period from time t94 to time t96, the memory controller 20 transmits an SCE packet (SCE(DOUT2) shown in FIG. 10) corresponding to the output data DOUT2 to the memory chip 11. In other words, the transmission of the SCT packet corresponding to the input data DIN1 is omitted. In the period from time t94 to time t95, the input of the input data DIN1 and the input of the SCE packet corresponding to the output data DOUT2 are executed in parallel.

At time t97, the memory controller 20 sets the signal RE_t to the "L" level (and the signal RE_c to the "H" level).

In the period from time t98 to time t101, as in the period from time t80 to time t83 described with reference to FIG. 9, the memory controller 20 repeatedly toggles the signal RE_t (and the signal RE_c). The memory chip 11 generates the signal DQS (and the signal DQS_c), based on the signal RE_t (and the signal RE_c).

The period from time t95 to t99 is a standby period of the signal DQ from the completion of the input of the input data DIN1 to the start of the output of the output data DOUT2.

In the period from time t99 to time t102, as in the period from time t81 to time t84 described with reference to FIG. 9, the memory chip 11 transmits the signal DQ corresponding to the output data DOUT2 to the memory controller 20 while repeatedly toggling the signal DQS.

In the period from time t100 to time t103, the memory controller 20 transmits an SCT packet (SCT(DOUT2) shown in FIG. 10) corresponding to the output data DOUT2 to the memory chip 11. In the period from time t100 to time t102, the output of the output data DOUT2 and the input of the SCT packet are executed in parallel.

### 1.3.4 Sequence for Successively Performing Data Output Operation and Data Input Operation

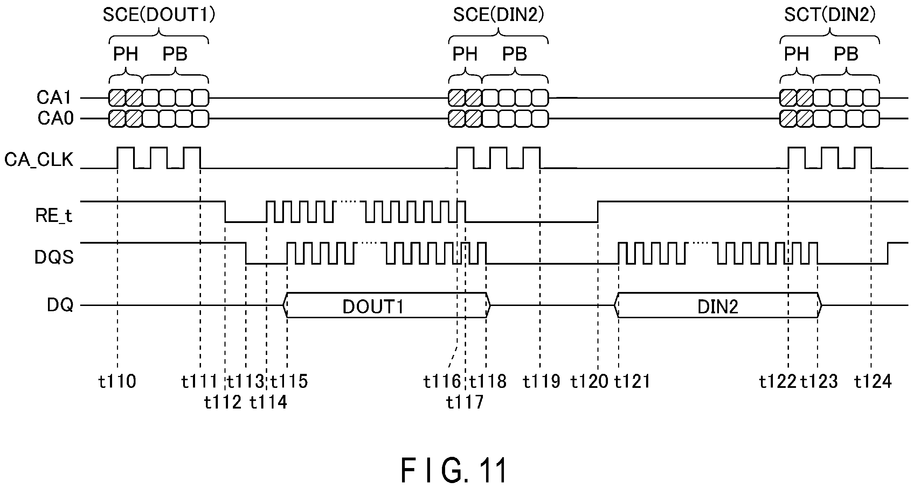

Next, with reference to FIG. 11, an example of a sequence for successively performing an output operation and an input operation of data DAT will be described. FIG. 11 is a diagram illustrating an example of the sequence for successively performing the output operation and input operation of the data DAT. FIG. 11 shows a case where an output operation of output data DOUT1 and an input operation of input data DIN2 are executed in succession. In the example shown in FIG. 11, the signal DQS_c, the signal CA_CE#, the signal RE_c, and the signal R/B_n are omitted. In addition, in order to simplify the description, the command CMD and the address ADD that instruct the execution of a transfer operation (input operation and output operation) of the data DAT are omitted in the example shown in FIG. 11.

As shown in FIG. 11, the memory controller 20 first executes the output operation of the output data DOUT1. The output operation of the output data DOUT1 executed in the period from time t110 to time t118 is similar to the output operation of the output data DOUT1 executed in the period from time t70 to time t78 described with reference to FIG. 9.

In the period from time t116 to time t119, the memory controller 20 transmits an SCE packet (SCE(DIN2) shown in FIG. 11) corresponding to the input data DIN2 to the memory chip 11. In other words, the transmission of the SCT packet corresponding to the output data DOUT1 is omitted. In the period from time t116 to time t118, the output of the output data DOUT1 and the input of the SCE packet corresponding to the input data DIN2 are executed in parallel.

At time t120, the memory controller 20 sets the signal RE_t to the "H" level (and the signal RE_c to the "L" level).

The period from time t118 to t121 is a standby period of the signal DQ from the completion of the output of the output data DOUT1 to the start of the input of the input data DIN2.

In the period from time t121 to time t123, as in the period from time t57 to time t59 described with reference to FIG. 8, the memory controller 20 transmits the signal DQ corresponding to the input data DIN2 to the memory chip 11 while repeatedly toggling the signal DQS. That is, the input data DIN2 is input to the input/output circuit 101.

In the period from time t122 to time t124, the memory controller 20 transmits an SCT packet (SCT(DIN2) shown in FIG. 11) corresponding to the input data DIN2 to the memory chip 11. In the period from time t122 to time t123, the input of the input data DIN2 and the input of the SCT packet are executed in parallel.

### 1.4 Advantages of Present Embodiment

With the configuration according to the present embodiment, the memory system 1 can improve the data transfer processing capacity. This advantage will be described in detail.

In a case where the SCA protocol is used for communication between the memory controller 20 and the memory chip 11, the memory controller 20 can perform transmission/reception of data DAT in parallel with the transmission of packets PK (a command CMD, an address ADD, an SCE packet, an SCT packet, etc.). In this case, the signal DQ corresponding to the data DAT and the signals CA0 and CA2 corresponding to the packet PK are transmitted between the memory controller 20 and the memory chip 11 via different signal lines. For example, in a case where a transfer operation of data DAT is executed between the memory controller 20 and the memory chip 11, the memory controller 20 transmits to the memory chip 11 an SCE packet indicating the start of the transfer operation of data DAT and an SCT packet indicating the end of the transfer operation of data DAT. For example, in a case where the transfer operation of the data DAT is executed twice in succession, the memory controller 20 transmits an SCT packet corresponding to the first transfer operation and an SCE packet corresponding to the second transfer operation between the first and second transfer operations. Therefore, in the signal line corresponding to the signal DQ, a standby period occurs between the transmission of data DAT for the first transfer operation and the transmission of data DAT for the second transfer operation, due to the transmission of the SCT packet and the SCE packet, resulting in a decrease in the data transfer processing capacity.

In contrast, with the configuration according to the present embodiment, in a case where transfer operations of data DAT are successively performed multiple times, the memory controller 20 transmits an SCT packet to the memory chip 11 only when the last transfer operation is completed. In other words, the memory controller 20 can omit the transmission of the SCT packet in the transfer operations other than the last transfer operation and transmit the SCE packet of the next transfer operation. This can shorten the standby period between data transmissions on the signal DQ. Therefore, the processing capacity of the memory system 1 can be improved.

### 2. Second Embodiment

Next, the second embodiment will be described. In the second embodiment, a configuration of the memory system 1 different from that of the first embodiment will be described. A description will now be given focusing on differences from the first embodiment.

### 2.1 Configuration of Memory System

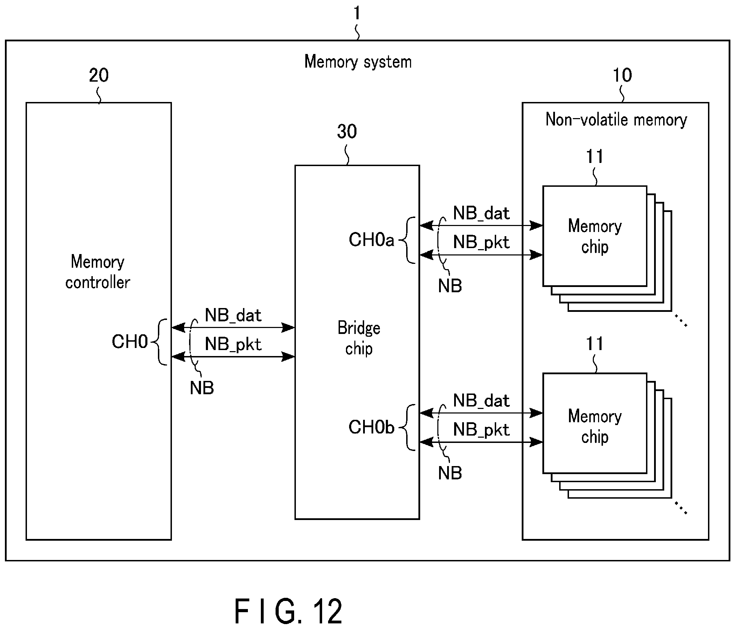

First, with reference to FIG. 12, an example of a configuration of a memory system 1 will be described. FIG. 12 is a block diagram illustrating an example of an overall configuration of the memory system 1. In the example shown in FIG. 12, some of the couplings between the components are indicated by arrows, but the couplings between the components are not limited to these. In addition, in the example shown in FIG. 12, the signal R/B_n transmitted via the NAND bus NB is omitted to simplify the description.

As shown in FIG. 12, the memory system 1 includes a non-volatile memory 10, a memory controller 20, and a bridge chip 30.

The configurations of the non-volatile memory 10 and the memory controller 20 are similar to those of the first embodiment. In the present embodiment, the memory controller 20 is coupled to the non-volatile memory 10 (memory chips 11) via the bridge chip 30.

The bridge chip 30 is an interface chip provided between the memory controller 20 and the non-volatile memory 10. The bridge chip 30 controls communication between the memory controller 20 and the non-volatile memory 10. The bridge chip 30 is coupled, for example, to one channel CH of the memory controller 20 via the NAND bus NB. The bridge chip 30 includes a plurality of channels CH corresponding to the couplings to the non-volatile memory 10. A NAND bus NB is coupled to each channel CH of the bridge chip 30. One or more memory chips 11 are coupled to each NAND bus NB that couples the bridge chip 30 and the non-volatile memory 10. In the example shown in FIG. 12, the bridge chip 30 is coupled to a channel CH0 of the memory controller 20 via the NAND bus NB. The bridge chip 30 also includes two channels CH0a and CH0b. A plurality of memory chips 11 are coupled to each of the channels CH0a and CH0b of the bridge chip 30 via a NAND bus NB. The communication between the memory controller 20 and the bridge chip 30 and the communication between the bridge chip 30 and the memory chips 11 conforms, for example, to the toggle double data rate (DDR) interface or the open NAND flash interface (ONFI).

For example, the bridge chip 30 includes a RAM (data buffer), not shown. With data DAT corresponding to each channel CH being stored in the RAM, data transfer operations in each channel CH can be executed in parallel.

For example, the data transfer speed between the memory controller 20 and the bridge chip 30 is set to be N times higher than the data transfer speed between the bridge chip 30 and the memory chip 11 (where N is an integer greater than 1). This increases the data transfer speed between the memory controller 20 and the plurality of memory chips 11.

### 2.2 Sequence for Successively Performing Data Transfer Operations Multiple Times

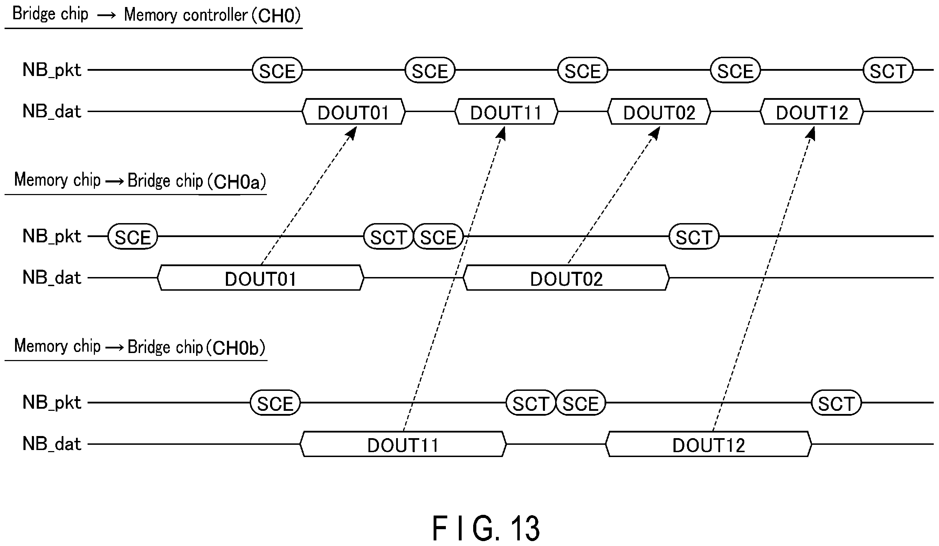

Next, with reference to FIG. 13, an example of a sequence for successively performing transfer operations (input operation and output operation) of data DAT multiple times will be described. FIG. 13 is a diagram illustrating an example of a sequence for successively performing output operations of the data DAT multiple times in the memory chip 11 coupled to channel CH0a of the bridge chip 30 and in the memory chip 11 coupled to channel CH0b of the same bridge chip. In the example shown in FIG. 13, the signal group NB_pkt corresponding to the packet PK and the signal group NB_dat corresponding to the data DAT are shown, and specific signals (signals DQ, DQS, DQS_c, CA_CE#, CA0, CA1, CA_CLK, RE_t, and RE_c) corresponding to the respective signal groups and signal R/B_n are omitted. In addition, in order to simplify the description, the command CMD and the address ADD that instruct the execution of the output operation (e.g., a read operation) of the data DAT are omitted in the example shown in FIG. 13.

In the present embodiment, in a case where a transfer operation of data DAT is executed once between the memory controller 20 and the bridge chip 30, the memory controller 20 transmits an SCE packet and an SCT packet to the bridge chip 30, as described with reference to FIGS. 6 and 7. In a case where transfer operations of data DAT are successively performed multiple times between the memory controller 20 and the bridge chip 30, the SCT packets between the successive transfer operations are omitted, as described with reference to FIGS. 8 to 11. The memory controller 20 transmits an SCT packet to the bridge chip 30 only when the last transfer operation is completed.

On the other hand, in a case where transfer operations of the data DAT are successively performed multiple times between the bridge chip 30 and the memory chips 11, the bridge chip 30 transmits an SCE packet and an SCT packet to the memory chip 11 each time a transfer operation is executed, as described with reference to FIG. 6 and FIG. 7. That is, between the successive transfer operations, an SCT packet corresponding to the previous transfer operation and an SCE packet corresponding to the next transfer operation are successively transmitted.

As shown in FIG. 13, for example, an output operation of output data DOUT01 and an output operation of output data DOUT02 are successively performed between the bridge chip 30 and the memory chip 11 coupled to the channel CH0a of the bridge chip 30. At this time, the bridge chip 30 transmits to the memory chip 11 an SCE packet and an SCT packet corresponding to the output data DOUT01 and an SCE packet and an SCT packet corresponding to the output data DOUT02. That is, the SCT packet and the SCE packet are transmitted between the transmission of the output data DOUT01 and the transmission of the output data DOUT02.

For example, the output operation of output data DOUT11 and the output operation of output data DOUT12 are successively performed between the bridge chip 30 and the memory chip 11 coupled to channel CH0b of the bridge chip 30. At this time, the bridge chip 30 transmits to the memory chip 11 an SCE packet and an SCT packet corresponding to the output data DOUT11 and an SCE packet and an SCT packet corresponding to the output data DOUT12. That is, the SCT packets and the SCE packets are transmitted between the transmission of the output data DOUT11 and the transmission of the output data DOUT12. The transfer operation on channel CH0a and the transfer operation on channel CH0b are performed in parallel at least in part.

Furthermore, the output operation of output data DOUT01, the output operation of output data DOUT11, the output operation of output data DOUT02, and the output operation of output data DOUT12 are successively performed between the memory controller 20 and the bridge chip 30, such that they are performed in parallel with the above-mentioned operations at least in part. At this time, the memory controller 20 transmits to the bridge chip 30 an SCE packet corresponding to the output data DOUT01, an SCE packet corresponding to the output data DOUT11, an SCE packet corresponding to the output data DOUT02, and an SCE packet and an SCT packet corresponding to the output data DOUT11. That is, the SCT packets between successive transfer operations are omitted.

The example in FIG. 13 shows a case where the transfer operation is an output operation of data DAT, but the same applies to the case where the transfer operation is an input operation of the data DAT. Further, in the transfer operation between the bridge chip 30 and the memory chip 11, SCT packets may be omitted between successive transfer operations.

### 2.3 Advantages of Present Embodiment

With the configuration according to the present embodiment, the advantages similar to those of the first embodiment can be obtained.

Furthermore, with the configuration according to the present embodiment, the memory system 1 can be provided with a bridge chip 30 between the memory controller 20 and the memory chip 11. In data transfer between the memory controller 20 and the bridge chip 30, SCT packets can be omitted between successive transfer operations. In addition, the data transfer speed between the memory controller 20 and the bridge chip 30 can be set to be N times higher than the data transfer speed between the bridge chip 30 and the memory chip 11. This improves the data transfer processing capacity.

Furthermore, with the configuration according to the present embodiment, the memory system 1 can use a data transfer method using SCE packets and SCT packets for each transfer operation, in the data transfer operations between the bridge chip 30 and the memory chip 11.

### 3. Third Embodiment

Next, the third embodiment will be described. In the third embodiment, a description will be given of the configuration of a memory system 1 different from the configurations of the first and second embodiments. A description will now be given focusing on the differences from the first and second embodiments.

### 3.1 Configuration of Memory System

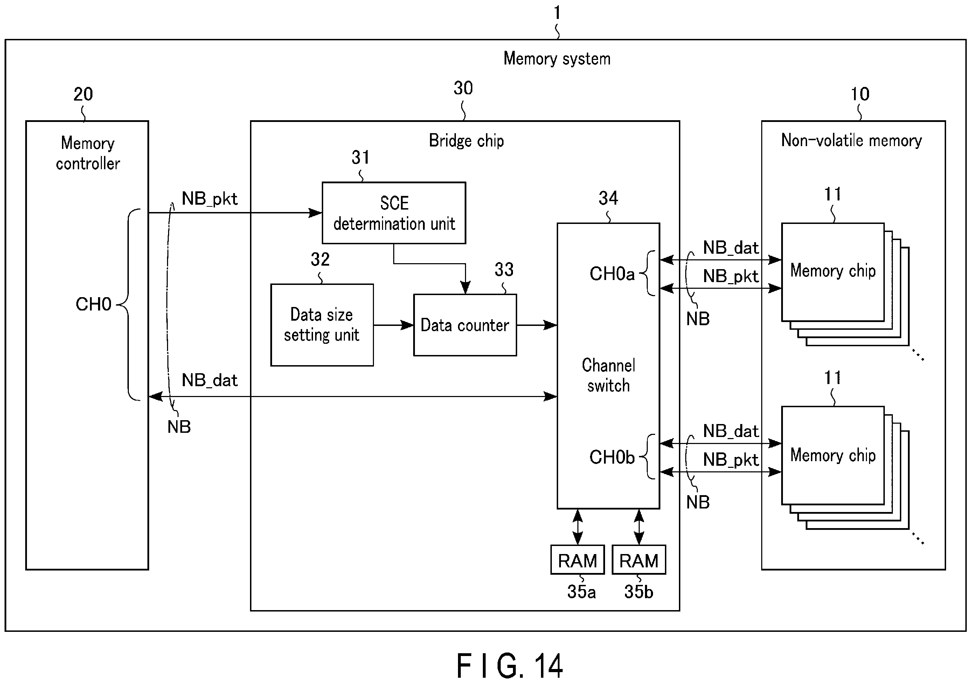

First, with reference to FIG. 14, an example of a configuration of the memory system 1 will be described. FIG. 14 is a block diagram illustrating an example of an overall configuration of the memory system 1. In the example shown in FIG. 14, some of the couplings between the components are indicated by arrows, but the couplings between the components are not limited to these. In addition, in the example shown in FIG. 14, a signal R/B_n transmitted via the NAND bus NB is omitted to simplify the description.

As shown in FIG. 14, the memory system 1 includes a non-volatile memory 10, a memory controller 20, and a bridge chip 30.

The configurations of the non-volatile memory 10 and the memory controller 20 are similar to those of the first embodiment. As in the second embodiment, the memory controller 20 is coupled to the non-volatile memory 10 (memory chips 11) via a plurality of channels CH of the bridge chip 30.

The bridge chip 30 includes an SCE determination unit 31, a data size setting unit 32, a data counter 33, a channel switch 34, and RAMs 35a and 35b.

The SCE determination unit 31 receives a signal group NB_pkt (i.e., signals CA_CE#, CA0, CA1, and CA_CLK) from the memory controller 20 via the NAND bus NB. If the packet PK is an SCE packet, the SCE determination unit 31 notifies the data counter 33 of the receipt of the SCE packet.

The data size setting unit 32 sets the data size of data DAT transmitted and received between the memory controller 20 and the memory chip 11 coupled to one channel CH, based on the control of the memory controller 20. In other words, the data size setting unit 32 sets the delimiter position of data for switching between channels CH0a and CH0b. The data size setting unit 32 transmits information on the set data size to the data counter 33. For example, in the case of a memory chip 11 with a large data size per page, it takes a long time to transfer data of the entire page. For this reason, in such a memory chip 11, one page of data is divided into several frames, and only the necessary frames are read during the read operation to shorten the data transfer time. The frame is a combination of data (user data) and an error correction code and will be hereinafter referred to as an "ECC frame." Since the ECC frame includes the error correction code, the memory controller 20 can safely read data in units of ECC frames. The data size setting unit 32 sets the data size of the ECC frame by register settings.

The data counter 33 counts the number of bits of data DAT transmitted and received to and from the memory controller 20. When the count reaches the data size set by the data size setting unit 32, the data counter 33 instructs the channel switch 34 to switch channels CH. The data size is dynamically switched by the data counter 33.

The channel switch 34 has a plurality of channels CH. In the example shown in FIG. 14, the channel switch 34 has two channels CH0a and CH0b. The two channels CH0a and CH0b are coupled to a plurality of memory chips 11 via NAND buses NB respectively coupled to them.

The channel switch 34 is coupled to RAMs 35a and 35b corresponding to the channels CH0a and CH0b, respectively. The RAM 35a temporarily stores the data DAT transmitted and received via the channel CH0a. Similarly, the RAM 35b temporarily stores the data DAT transmitted and received via the channel CH0b. In the description below, in a case where the RAM 35a and 35b need not be distinguished, they will be referred to simply as "RAM 35." The number of RAMs 35 coupled to the channel switch 34 is arbitrary. The number of RAMs 35 is based on the number of channels of the channel switch 34.

The channel switch 34 transmits and receives a signal group NB_dat to and from the memory controller 20. That is, the channel switch 34 transmits and receives the data DAT to and from the memory controller 20. The channel switch 34 selects one of the RAMs 35 corresponding to the channels CH, and transmits and receives the corresponding data DAT to and from the memory controller 20. In other words, the channel switch 34 selects the RAM 35 that transmits and receives the data DAT to and from the memory controller 20. The channel switch 34 switches channels CH, i.e., RAMs 35, based on the control of the data counter 33. For example, in a case where the memory chip 11 coupled to the channel CH0a and the memory chip 11 coupled to the channel CH0b each output the output data DOUT, the channel switch 34 switches the channel CH under the control of the data counter 33. That is, the channel switch 34 switches RAMs 35 that transmit the output data DOUT to the memory controller 20, based on the data count number. This allows the channel switch 34 to dynamically switch between data on the plurality of channels CH without requiring standby periods between transfer operations of the data DAT.

### 3.2 Sequence for Successively Performing Data Output Operations Multiple Times

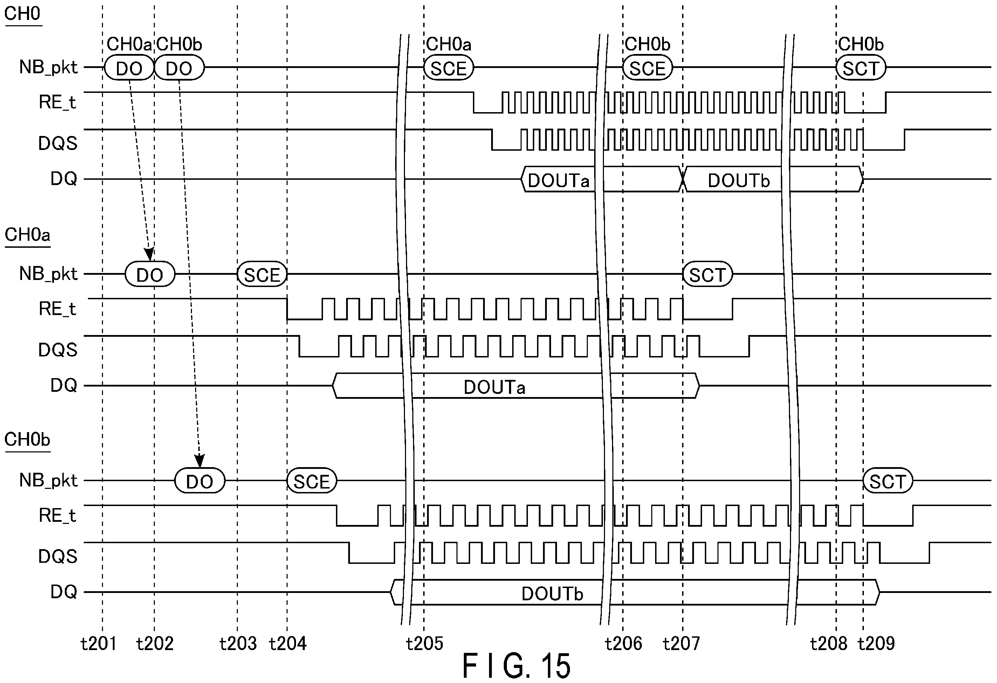

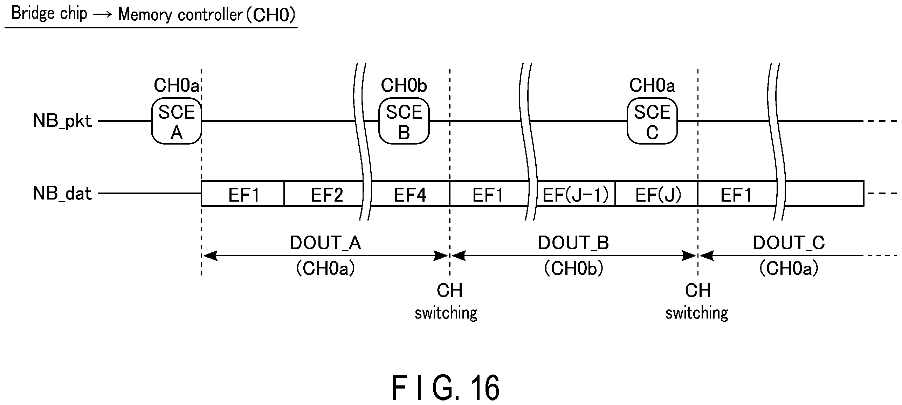

Next, with reference to FIGS. 15 and 16, a description will be given of an example of a sequence for successively performing output operations of data DAT multiple times. FIGS. 15 and 16 are diagrams illustrating an example of the case where the bridge chip 30 outputs the output data DOUT to the memory controller 20. In the example shown in FIGS. 15 and 16, the bridge chip 30 successively performs output operations of data DAT while alternately switching between channel CH0a and channel CH0b.

The example in FIG. 15 shows a case where the bridge chip 30 successively outputs to the memory controller 20 output data DOUTa received from the memory chip 11 coupled to the channel CH0a and output data DOUTb received from the memory chip 11 coupled to the channel CH0b. In the example shown in FIG. 15, a signal group NB_pkt corresponding to a packet PK and signals DQ, DQS and RE_t of a signal group NB_dat are shown, and other signals (signals DQS_c, RE_c, and R/B_n) are omitted.

In the present embodiment, as in the second embodiment, in a case where the transfer operation of data DAT is performed once between the memory controller 20 and the bridge chip 30, the memory controller 20 transmits the SCE packet and the SCT packet to the bridge chip 30. In a case where the transfer operation of the data DAT is successively performed multiple times between the memory controller 20 and the bridge chip 30, the SCT packets between the successive transfer operations are omitted. The memory controller 20 transmits the SCT packet to the bridge chip 30 only when the final transfer operation is completed.

As shown in FIG. 15, at time t201, for example, the memory controller 20 first transmits a DO command (a packet PK corresponding thereto) to the bridge chip 30 via channel CH0, in order to instruct the memory chip 11 coupled to CH0a to execute the output operation of the data DAT. The bridge chip 30 transmits the DO command to the target memory chip 11 coupled to channel CH0a.

Next, at time t202, the memory controller 20 transmits the DO command to the bridge chip 30 via channel CH0, in order to instruct the memory chip 11 coupled to CH0b to execute the output operation of the data DAT. The bridge chip 30 transmits the DO command to the target memory chip 11 coupled to channel CH0b.

In the case of the output operation (read operation) of the data DAT, output of the data DAT from the memory chip 11 to the bridge chip 30 is started prior to output of the data DAT from the bridge chip 30 to the memory controller 20.

More specifically, at time t203, which is a time before an SCE packet is received from the memory controller 20, the bridge chip 30 issues an SCE packet and transmits the SCE packet to the target memory chip 11 coupled to channel CH0a. After transmitting the SCE packet, the bridge chip 30 sets the signal RE_t to the "L" level. Thereafter, the bridge chip 30 starts toggling the signal RE_t. The target memory chip 11 coupled to the channel CH0a generates a signal DQS, based on the signal RE_t. The target memory chip 11 coupled to the channel CH0a starts outputting signals DQ and DQS to the bridge chip 30. That is, the target memory chip 11 coupled to the channel CH0a starts outputting output data DOUTa to the bridge chip 30. The output data DOUTa is stored in the RAM 35a.

Next, at time t204, which is a time before an SCE packet is received from the memory controller 20, the bridge chip 30 issues an SCE packet and transmits the SCE packet to the target memory chip 11 coupled to channel CH0b. After transmitting the SCE packet, the bridge chip 30 sets the signal RE_t to the "L" level and then starts toggling the signal RE_t. The target memory chip 11 coupled to the channel CH0b generates a signal DQS, based on the signal RE_t. The target memory chip 11 coupled to the channel CH0b starts outputting the signals DQ and DQS to the bridge chip 30. That is, the target memory chip 11 coupled to the channel CH0b starts outputting output data DOUTb to the bridge chip 30. The output data DOUTb is stored in the RAM 35b.

Next, at time t205, the memory controller 20 transmits an SCE packet corresponding to the channel CH0a to the bridge chip 30 via channel CH0. The SCE determination unit 31 notifies the data counter 33 of the receipt of the SCE packet corresponding to the channel CH0a. The channel switch 34 selects the RAM 35a corresponding to the channel CH0a under the control of the data counter 33. After transmitting the SCE packet corresponding to the channel CH0a, the memory controller 20 sets the signal RE_t to the "L" level and then starts toggling the signal RE_t. The bridge chip 30 generates a signal DQS, based on the signal RE_t. The bridge chip 30 selects the RAM 35a and starts outputting the signals DQ and DQS to the memory controller 20. That is, the bridge chip 30 starts outputting the output data DOUTa from the RAM 35a to the memory controller 20. The data counter 33 counts the number of bits of the output data DOUTa output from the channel switch 34 to the memory controller 20.

Next, at time t206, which is a time when the data counter 33 is counting the number of bits of the output data DOUTa, the memory controller 20 transmits an SCE packet corresponding to the channel CH0b to the bridge chip 30 via channel CH0. That is, the memory controller 20 can finish transmitting the SCE packet corresponding to the next data DAT before the transfer of the previous data DAT is finished. The SCE determination unit 31 notifies the data counter 33 of the receipt of the SCE packet corresponding to the channel CH0b.

Next, at time t207, when the count number of the output data DOUTa reaches the predetermined count number, the data counter 33 instructs the channel switch 34 to switch channels CH. The channel switch 34 switches from the RAM 35a corresponding to the channel CH0a to the RAM 35b corresponding to the channel CH0b. That is, the bridge chip 30 switches the output data to the memory controller 20 from the output data DOUTa to the output data DOUTb. Furthermore, simultaneously with the switching from the RAM 35a corresponding to channel CH0a to the RAM 35b corresponding to the channel CH0b, the bridge chip 30 issues an SCT packet and transmits the SCT packet to the target memory chip 11 coupled to the channel CH0a. Furthermore, the bridge chip 30 ends the toggling of the signal RE_t on the channel CH0a, and sets the signal RE_t to the "H" level. Thus, the memory chip 11 coupled to channel CHa ends the output operation.

The bridge chip 30 starts outputting the output data DOUTb without providing a standby period between the output operation of the output data DOUTa and the output operation of the output data DOUTb. The data counter 33 counts the number of bits of the output data DOUTb output from the channel switch 34 to the memory controller 20.

Next, at time t208, which is a time when the data counter 33 is counting the number of bits of the output data DOUTb, the memory controller 20 transmits an SCT packet corresponding to the channel CH0b to the bridge chip 30 via channel CH0. In addition, the memory controller 20 ends the toggling of the signal RE_t, and sets the signal RE_t to the "H" level.

Next, at time t209, the bridge chip 30 issues an SCT packet, based on the SCT packet received from the memory controller 20, and transmits the SCT packet to the target memory chip 11 coupled to the channel CH0b. Also, the bridge chip 30 ends the toggling of signal RE_t on the channel CH0b, setting the signal RE_t to the "H" level. This causes the memory chip 11 coupled to channel CHb to end the output operation.

Next, the relationship between the switching timings of SCE packets and channels CH will be described, focusing on the ECC frame EF.

The example in FIG. 16 shows a case where the bridge chip 30 successively outputs output data DOUT_A, output data DOUT_B, and output data DOUT_C to the memory controller 20. In the example shown in FIG. 16, each piece of output data DOUT includes one or more ECC frames EF. In the example shown in FIG. 16, a signal group NB_pkt corresponding to the packet PK and a signal group NB_dat corresponding to the data DAT are shown, and specific signals corresponding to each signal group (signals DQ, DQS, DQS_c, CA_CE#, CA0, CA1, CA_CLK, RE_t, and RE_c) and a signal R/B_n are omitted. In addition, in order to simplify the description, the transmission and reception of the signal group NB_pkt and the signal group NB_dat between the bridge chip 30 and the memory chip 11 are omitted in the example shown in FIG. 16.

As shown in FIG. 16, for example, the memory controller 20 transmits an SCE packet (SCE A) corresponding to the output data DOUT_A to the bridge chip 30. For example, the SCE packet (SCE A) corresponds to channel CH0a. The channel switch 34 selects the channel CH0a based on the SCE packet (SCE A). The bridge chip 30 starts outputting the output data DOUT_A to the memory controller 20. For example, the output data DOUT_A includes four ECC frames EF1 to EF4. In this case, the memory controller 20 transmits an SCE packet (SCE B) corresponding to the output data DOUT_B to the bridge chip 30 when it is still receiving the ECC frame EF4 of the output data DOUT_A. For example, the SCE packet (SCE B) corresponds to a channel CH0b.

When the data counter 33 finishes counting the ECC frames EF4 of the output data DOUT_A, the data counter 33 instructs the channel switch 34 to switch from the channel CH0a to the channel CH0b. The channel switch 34 switches from the channel CH0a to the channel CH0b, based on the instruction of the data counter 33. The bridge chip 30 transmits an SCT packet to the target memory chip 11 coupled to the channel CH0a and stops toggling the signals RE_t and RE_c. This stops the output operation using the channel CH0a. When counting the ECC frames EF4 of the output data DOUT_A ends, the bridge chip 30 starts outputting the output data DOUT_B without a standby period being provided between the output operation of the output data DOUT_A and the output operation of the output data DOUT_B. For example, the output data DOUT_B includes J ECC frames EF1 to EF(J) (J is an integer equal to or greater than 2). In this case, the memory controller 20 transmits an SCE packet (SCE C) corresponding to the output data DOUT_C to the bridge chip 30 when it is still receiving the ECC frame EF(J). For example, the SCE packet (SCE C) corresponds to the channel CH0a.

When the data counter 33 finishes counting the ECC frames EF(J) of the output data DOUT_B, the data counter 33 instructs the channel switch 34 to switch from the channel CH0b to the channel CH0a. The channel switch 34 switches from the channel CH0b to the channel CH0a, based on an instruction from the data counter 33. The bridge chip 30 transmits an SCT packet to the target memory chip 11 coupled to the channel CH0b and stops toggling the signals RE_t and RE_c. This stops the output operation using the channel CH0b. When counting the ECC frames EF(J) of the output data DOUT_B ends, the bridge chip 30 starts outputting the output data DOUT_C without a standby period being provided between the output operation of the output data DOUT_B and the output operation of the output data DOUT_C.

### 3.3 Advantages of Present Embodiment

The configuration according to the present embodiment can provide similar advantages to those of the first and second embodiments.

Furthermore, the configuration according to the present embodiment allows the bridge chip 30 to set the size of an ECC frame of the data DAT transmitted and received between the memory chip 11 coupled to one channel CH and the memory controller 20. Thus, the bridge chip 30 can set the delimiter position of the data DAT for switching between channel CH0a and channel CH0b. The bridge chip 30 can count the number of bits of the data DAT transmitted and received to and from the memory controller 20. This allows the bridge chip 30 to switch channels CH, based on the data size of the data DAT. Therefore, the memory controller 20 can end the transmission of an SCE packet corresponding to the output operation of the next data DAT while the previous data DAT is being output. Therefore, when the count number of the previous data DAT reaches the set value, the bridge chip 30 can switch channels CH and start outputting the next data DAT without providing a standby period. This improves the data transfer processing capacity.

Furthermore, with the configuration according to the present embodiment, in a case where the data DAT transfer operations are successively performed multiple times, the memory controller 20 can start transmitting the SCE packet corresponding to the next transfer operation during the transfer of previous data. This can shorten the standby period between data transmissions on the signal DQ. Therefore, the processing capacity of the memory system 1 can be improved.

### 4. Further Embodiments, etc.

The memory system according to the above embodiment includes a memory chip (11) including a first terminal group (TMG1) used for transmitting and receiving data (DAT) and a second terminal group (TM2) used for receiving a packet (PK), and configured to store the data in a non-volatile manner, and a memory controller (20) configured to control the memory chip, transmit and receive the data to and from the memory chip via the first terminal group, and transmit the packet to the memory chip via the second terminal group. In a case where a transfer operation of the data to the memory chip is performed once, the memory controller transmits to the memory chip a first packet (SCE) indicating a start of data transfer and a second packet (SCT) indicating end of the data transfer. In a case where the transfer operation of the data to the memory chip is successively performed twice, the memory controller transmits to the memory chip the first packet corresponding to a second data transfer between a first data transfer and the second data transfer, and does not transmit the second packet corresponding to the first data transfer.

With the configuration according to the above embodiment, the data transfer processing capacity can be improved.

Various modifications can be made without being limited to the above embodiments.

Furthermore, the "coupling" in the above embodiments includes a state where the coupling is indirect, with some element, such as a translator or a resistor, interposed in between.

While certain embodiments have been described, these embodiments have been presented by way of example only, and are not intended to limit the scope of the inventions. Indeed, the novel devices and methods described herein may be embodied in a variety of other forms; furthermore, various omissions, substitutions and changes in the form of the embodiments described herein may be made without departing from the scope of the inventions.

Some or all of the embodiments described above can be described as in the following supplementary notes, but is not limited thereto:

### [Supplementary Note 1]

A memory system comprising:
a memory chip (11) including a first terminal group (TMG1) used for transmitting and receiving data (DAT) and a second terminal group (TMG2) used for receiving a packet (PK), and configured to store the data in a non-volatile manner; and
a memory controller (20) configured to control the memory chip, transmit and receive the data to and from the memory chip via the first terminal group, and transmit the packet to the memory chip via the second terminal group,
wherein
in a case where a transfer operation of the data to the memory chip is performed once, the memory controller transmits to the memory chip a first packet (SCE) indicating a start of data transfer and a second packet (SCT) indicating end of the data transfer, and
in a case where the transfer operation of the data to the memory chip is successively performed twice, the memory controller transmits to the memory chip the first packet corresponding to a second data transfer between a first data transfer and the second data transfer, and does not transmit the second packet corresponding to the first data transfer.

### [Supplementary Note 2]

The memory system according to Supplementary Note 1, wherein
in a case where the transfer operation of the data to the memory chip is successively performed twice, the memory controller transmits the first packet corresponding to the first data transfer to the memory chip before the first data transfer, and transmits the second packet corresponding to the second data transfer after the second data transfer.

### [Supplementary Note 3]

The memory system according to Supplementary Note 1 or 2, wherein the memory controller executes a part of transmission of the first packet or the second packet to the memory chip and a part of transmission and reception of the data to the memory chip in parallel.

### [Supplementary Note 4]

The memory system according to any of Supplementary Notes 1 to 3, where each of the first packet and the second packet includes a packet header (PH) indicating types of information and a packet body (PB) indicating contents of information.

### [Supplementary Note 5]

The memory system according to Supplementary Note 4, wherein the types of information include a command (CMD), an address (ADD) and status information (STS).

### [Supplementary Note 6]

The memory system according to any of Supplementary Notes 1 to 5, wherein the first terminal group includes a first terminal (TM) used for input/output of a first signal (DQ) indicating the data, a second terminal (TM) used for input/output of a strobe signal (DQS) of the first signal, and a third terminal (TM) used for input of a read enable signal.(RE)

### [Supplementary Note 7]

The memory system according to any of Supplementary Notes 1 to 6, wherein the second terminal group includes a fourth terminal (TM) used for input/output of a second signal (CA0) indicating the first packet and the second packet, a fifth terminal (TM) used for transmission of a strobe signal (CA_CLK) of the second signal, and a sixth terminal (TM) used for input of a chip enable signal(CA_CE) .

### [Supplementary Note 8]

The memory system according to Supplementary Note 7, wherein the memory chip captures the second signal received from the fourth terminal, based on rising and falling of the strobe signal received from the fifth terminal.

### [Supplementary Note 9]

A memory system comprising:
a first memory chip (11) and a second memory chip (11), each of which includes a first terminal group (TMG1) used for transmitting and receiving data (DAT) and a second terminal group (TMG2) used for receiving a packet (PK), and each of which is configured to store the data in a non-volatile manner;
a bridge chip (30) coupled to the first terminal group and the second terminal group of the first memory chip via a first channel (CH0a) and coupled to the first terminal group and the second terminal group of the second memory chip via a second channel (CH0b); and
a memory controller (20) coupled to the bridge chip and transmitting and receiving the data to and from the first memory chip and the second memory chip via the bridge chip,
wherein
in a case where a transfer operation of the data to the bridge chip is performed once, the memory controller transmits to the bridge chip a first packet (SCE) indicating a start of data transfer from the bridge chip to the memory controller and a second packet (SCT) indicating end of the data transfer from the bridge chip to the memory controller, and
in a case where the transfer operation of the data to the bridge chip is successively performed twice, the memory controller transmits to the bridge chip the first packet corresponding to a second data transfer between a first data transfer and the second data transfer, and does not transmit the second packet corresponding to the first data transfer.

### [Supplementary Note 10]

The memory system according to Supplementary Note 9, wherein
in a case where the transfer operation of the data to the bridge chip is successively performed twice, the memory controller transmits to the bridge chip the first packet corresponding to the first data transfer before the first data transfer, and transmits the second packet corresponding to the second data transfer after the second data transfer.

### [Supplementary Note 11]

The memory system according to Supplementary Note 9 or 10, wherein the memory controller executes a part of transmission of the first packet or the second packet to the bridge chip and a part of transmission and reception of the data to and from the bridge chip in parallel.

### [Supplementary Note 12]

The memory system according to any of Supplementary Notes 9 to 11, wherein
in a case where the transfer operation of the data to the first memory is successively performed twice, the bridge chip transmits to the first memory chip a third packet (SCE) indicating a start of data transfer corresponding to a first transfer operation from the first memory chip to the bridge chip, a fourth packet (SCT) indicating end of the data transfer corresponding to the first transfer operation from the first memory chip to the bridge chip, the third packet corresponding to a second transfer operation from the first memory chip to the bridge chip, and the fourth packet corresponding to the second transfer operation from the first memory chip to the bridge chip.

### [Supplementary Note 13]

The memory system according to any of Supplementary Notes 9 to 12, wherein the bridge chip executes a part of the transfer operation of the data to the first memory chip and a part of the transfer operation of the data to the second memory chip in parallel.

### [Supplementary Note 14]

The memory system according to any of Supplementary Notes 9 to 13, wherein
in a case where the data is transmitted from the first memory chip to the memory controller, the bridge chip transmits a third packet (SCE) indicating a start of data transfer from the first memory chip to the bridge chip before the first packet is received from the memory controller.

### [Supplementary Note 15]

The memory system according to any of Supplementary Notes 9 to 14, wherein a data transfer speed between the memory controller and the bridge chip is higher than a data transfer speed between the bridge chip and the first memory chip or the second memory chip.

### [Supplementary Note 16]

A memory system comprising:
a first memory chip (11) and a second memory chip (11), each of which includes a first terminal group (TMG1) used for transmitting and receiving data (DAT) and a second terminal group (TMG2) used for receiving a packet (PK), and each of which is configured to store the data in a non-volatile manner;
a bridge chip (30) coupled to the first terminal group and the second terminal group of the first memory chip via a first channel (CH0a) and coupled to the first terminal group and the second terminal group of the second memory chip via a second channel (CHOb); and
a memory controller (20) coupled to the bridge chip and transmitting and receiving the data to and from the first memory chip and the second memory chip via the bridge chip,
wherein the bridge chip includes:
   a determination unit (31) that determines whether a first packet (SCE) indicating a start of data transfer is received from the memory controller;
   a setting unit (32) that sets a data size of transfer data;
   a counter(33) that counts the transfer data;
   a first memory (35a) corresponding to the first channel;
   a second memory (35b) corresponding to the second channel; and
   a switch (34) that couples one of the first memory and the second memory to the memory controller and switches to another one of the first memory and the second memory, based on a count number of the transfer data.

### [Supplementary Note 17]

The memory system according to Supplementary Note 16, wherein
in a case where a transfer operation of first data (DOUTa) from the first memory chip to the memory controller and a transfer operation of second data (DOUTb) from the second memory chip to the memory controller are executed in succession, the counter instructs the switch to switch the coupling to the memory controller from the first memory to the second memory upon a count number of the first data reaching a set data size.

### [Supplementary Note 18]

The memory system according to Supplementary Note 17, wherein the memory controller transmits the first packet corresponding to the transfer operation of the second data to the bridge chip during transfer of the first data from the bridge chip to the memory controller, and does not transmit a second packet (SCT) indicating end of the data transfer corresponding to the transfer operation of the first data.

### [Supplementary Note 19]

The memory system according to Supplementary Note 18, wherein the first data includes a plurality of data frames (EF1 - EF4), and
the memory controller transmits the first packet corresponding to the transfer operation of the second data to the bridge chip during transfer of a last data frame (EF4) of the plurality of data frames from the bridge chip to the memory controller.

### [Supplementary Note 20]

The memory system according to any of Supplementary Notes 17 to 19, wherein
upon receipt of a command (DO) from the memory controller indicating execution of an output operation of the first data to the memory chip, the bridge chip transmits to the first memory chip a third packet (SCE) indicating a start of data transfer corresponding to the output operation of the first data from the first memory chip to the bridge chip before the first packet corresponding to the transfer operation of the first data is received from the memory controller.

## Claims

1. A memory system comprising:
a memory chip (11) including a first terminal group (TMG1) used for transmitting and receiving data (DAT) and a second terminal group (TMG2) used for receiving a packet (PK), and configured to store the data in a non-volatile manner; and
a memory controller (20) configured to control the memory chip, transmit and receive the data to and from the memory chip via the first terminal group, and transmit the packet to the memory chip via the second terminal group,
wherein
in a case where a transfer operation of the data to the memory chip is performed once, the memory controller transmits to the memory chip a first packet (SCE) indicating a start of data transfer and a second packet (SCT) indicating end of the data transfer, and
in a case where the transfer operation of the data to the memory chip is successively performed twice, the memory controller transmits to the memory chip the first packet corresponding to a second data transfer between a first data transfer and the second data transfer, and does not transmit the second packet corresponding to the first data transfer.

2. The memory system according to claim 1, wherein
in a case where the transfer operation of the data to the memory chip is successively performed twice, the memory controller transmits the first packet corresponding to the first data transfer to the memory chip before the first data transfer, and transmits the second packet corresponding to the second data transfer after the second data transfer.

3. The memory system according to claim 1 or 2,
wherein the memory controller executes a part of transmission of the first packet or the second packet to the memory chip and a part of transmission and reception of the data to the memory chip in parallel.

4. The memory system according to any of claims 1 to 3, where each of the first packet and the second packet includes a packet header (PH) indicating types of information and a packet body (PB) indicating contents of information.

5. The memory system according to claim 4, wherein the types of information include a command (CMD), an address (ADD) and status information (STS).

6. The memory system according to any of claims 1 to 5, wherein the first terminal group includes a first terminal (TM) used for input/output of a first signal (DQ) indicating the data, a second terminal (TM) used for input/output of a strobe signal (DQS) of the first signal, and a third terminal (TM) used for input of a read enable signal.(RE)

7. The memory system according to any of claims 1 to 6, wherein the second terminal group includes a fourth terminal (TM) used for input/output of a second signal (CA0) indicating the first packet and the second packet, a fifth terminal (TM) used for transmission of a strobe signal (CA_CLK) of the second signal, and a sixth terminal (TM) used for input of a chip enable signal(CA_CE).

8. The memory system according to claim 7, wherein the memory chip captures the second signal received from the fourth terminal, based on rising and falling of the strobe signal received from the fifth terminal.

9. A memory system comprising:
a first memory chip (11) and a second memory chip (11), each of which includes a first terminal group (TMG1) used for transmitting and receiving data (DAT) and a second terminal group (TMG2) used for receiving a packet (PK), and each of which is configured to store the data in a non-volatile manner;
a bridge chip (30) coupled to the first terminal group and the second terminal group of the first memory chip via a first channel (CH0a) and coupled to the first terminal group and the second terminal group of the second memory chip via a second channel (CHOb); and
a memory controller (20) coupled to the bridge chip and transmitting and receiving the data to and from the first memory chip and the second memory chip via the bridge chip,
wherein
in a case where a transfer operation of the data to the bridge chip is performed once, the memory controller transmits to the bridge chip a first packet (SCE) indicating a start of data transfer from the bridge chip to the memory controller and a second packet (SCT) indicating end of the data transfer from the bridge chip to the memory controller, and
in a case where the transfer operation of the data to the bridge chip is successively performed twice, the memory controller transmits to the bridge chip the first packet corresponding to a second data transfer between a first data transfer and the second data transfer, and does not transmit the second packet corresponding to the first data transfer.

10. The memory system according to claim 9, wherein
in a case where the transfer operation of the data to the bridge chip is successively performed twice, the memory controller transmits to the bridge chip the first packet corresponding to the first data transfer before the first data transfer, and transmits the second packet corresponding to the second data transfer after the second data transfer.

11. The memory system according to claim 9 or 10,
wherein the memory controller executes a part of transmission of the first packet or the second packet to the bridge chip and a part of transmission and reception of the data to and from the bridge chip in parallel.

12. The memory system according to any of claims 9 to 11, wherein
in a case where the transfer operation of the data to the first memory is successively performed twice, the bridge chip transmits to the first memory chip a third packet (SCE) indicating a start of data transfer corresponding to a first transfer operation from the first memory chip to the bridge chip, a fourth packet (SCT) indicating end of the data transfer corresponding to the first transfer operation from the first memory chip to the bridge chip, the third packet corresponding to a second transfer operation from the first memory chip to the bridge chip, and the fourth packet corresponding to the second transfer operation from the first memory chip to the bridge chip.

13. The memory system according to any of claims 9 to 12, wherein the bridge chip executes a part of the transfer operation of the data to the first memory chip and a part of the transfer operation of the data to the second memory chip in parallel.

14. The memory system according to any of claims 9 to 13, wherein
in a case where the data is transmitted from the first memory chip to the memory controller, the bridge chip transmits a third packet (SCE) indicating a start of data transfer from the first memory chip to the bridge chip before the first packet is received from the memory controller.

15. The memory system according to any of claims 9 to 14, wherein a data transfer speed between the memory controller and the bridge chip is higher than a data transfer speed between the bridge chip and the first memory chip or the second memory chip.

16. A memory system comprising:
a first memory chip (11) and a second memory chip (11), each of which includes a first terminal group (TMG1) used for transmitting and receiving data (DAT) and a second terminal group (TMG2) used for receiving a packet (PK), and each of which is configured to store the data in a non-volatile manner;
a bridge chip (30) coupled to the first terminal group and the second terminal group of the first memory chip via a first channel (CH0a) and coupled to the first terminal group and the second terminal group of the second memory chip via a second channel (CHOb); and
a memory controller (20) coupled to the bridge chip and transmitting and receiving the data to and from the first memory chip and the second memory chip via the bridge chip,
wherein the bridge chip includes:
a determination unit (31) that determines whether a first packet (SCE) indicating a start of data transfer is received from the memory controller;
a setting unit (32) that sets a data size of transfer data;
a counter(33) that counts the transfer data;
a first memory (35a) corresponding to the first channel;
a second memory (35b) corresponding to the second channel; and
a switch (34) that couples one of the first memory and the second memory to the memory controller and switches to another one of the first memory and the second memory, based on a count number of the transfer data.

17. The memory system according to claim 16, wherein
in a case where a transfer operation of first data (DOUTa) from the first memory chip to the memory controller and a transfer operation of second data (DOUTb) from the second memory chip to the memory controller are executed in succession, the counter instructs the switch to switch the coupling to the memory controller from the first memory to the second memory upon a count number of the first data reaching a set data size.

18. The memory system according to claim 17, wherein the memory controller transmits the first packet corresponding to the transfer operation of the second data to the bridge chip during transfer of the first data from the bridge chip to the memory controller, and does not transmit a second packet (SCT) indicating end of the data transfer corresponding to the transfer operation of the first data.

19. The memory system according to claim 18, wherein the first data includes a plurality of data frames (EF1 - EF4), and
the memory controller transmits the first packet corresponding to the transfer operation of the second data to the bridge chip during transfer of a last data frame (EF4) of the plurality of data frames from the bridge chip to the memory controller.

20. The memory system according to any of claims 17 to 19, wherein
upon receipt of a command (DO) from the memory controller indicating execution of an output operation of the first data to the memory chip, the bridge chip transmits to the first memory chip a third packet (SCE) indicating a start of data transfer corresponding to the output operation of the first data from the first memory chip to the bridge chip before the first packet corresponding to the transfer operation of the first data is received from the memory controller.
